# EUROPEAN PATENT APPLICATION

(11) **EP 4 716 422 A1**
(43) Date of publication of application: **25.03.2026**
(21) Application number: 25817122.2
(22) Date of filing: 17.06.2025
(51) Int. Cl.: H10F 77/20, H10F 77/14

(54) **BACK-CONTACT BATTERY AND MANUFACTURING METHOD THEREFOR, AND PHOTOVOLTAIC MODULE**

(30) Priority: 18.06.2024 CN 202410788218; 03.09.2024 CN 202411231314; 30.09.2024 CN 202411388833; 17.06.2024 CN 202410780833; 06.01.2025 CN 202520025111 U; 10.07.2024 CN 202410918517
(71) Applicant: Longi Green Energy Technology Co., Ltd., Xi'an, Shaanxi 710100 (CN)
(72) Inventor: XU, Xixiang, Xi'an, Shaanxi 710100 (CN); LI, Yunpeng, Xi'an, Shaanxi 710100 (CN); WEI, Junzhe, Xi'an, Shaanxi 710100 (CN); YU, Mingzhe, Xi'an, Shaanxi 710100 (CN); GE, Xi, Xi'an, Shaanxi 710100 (CN); CHEN, Jiansheng, Xi'an, Shaanxi 710100 (CN); YE, Feng, Xi'an, Shaanxi 710100 (CN); FANG, Liang, Xi'an, Shaanxi 710100 (CN); LI, Zhenguo, Xi'an, Shaanxi 710100 (CN)
(74) Representative: Pfenning, Meinig & Partner mbB
(86) International application number: PCT/CN2025/101505
(87) International publication number: WO 2025/261353

(57) **Abstract**

The present application discloses a back contact solar cell and a manufacturing method thereof, and a photovoltaic module, and relates to the field of photovoltaic technologies, so that the back contact solar cell has a low hot spot risk, and the operating reliability of the back contact solar cell is improved. In addition, the back contact solar cell has high operating efficiency in a forward voltage region. The back contact solar cell includes a semiconductor substrate, a first doped semiconductor layer, a second doped semiconductor layer, and a transparent conductive layer. The second doped semiconductor layer includes a reverse leakage part, where the reverse leakage part is electrically connected to the first doped semiconductor layer, and the reverse leakage part is covered by the transparent conductive layer extending from the second region.

## Description

The present application claims priorities to Chinese Patent Application No. 202410788218.1, filed with the China National Intellectual Property Administration on June 18, 2024 and entitled "BACK CONTACT SOLAR CELL AND MANUFACTURING METHOD THEREOF, AND PHOTOVOLTAIC MODULE", Chinese Patent Application No. 202410918517.2, field with the China National Intellectual Property Administration on July 10, 2024 and entitled "BACK CONTACT SOLAR CELL AND MANUFACTURING METHOD THEREOF, AND PHOTOVOLTAIC MODULE", Chinese Patent Application No. 202410780833.8, filed with the China National Intellectual Property Administration on June 17, 2024 and entitled "BACK CONTACT SOLAR CELL AND PREPARATION METHOD THEREOF, AND PHOTOVOLTAIC MODULE", Chinese Patent Application No. 202411231314.2, filed with the China National Intellectual Property Administration on September 3, 2024 and entitled "BACK CONTACT SOLAR CELL AND MANUFACTURING METHOD THEREOF, AND PHOTOVOLTAIC MODULE", Chinese Patent Application No. 202411388833.X, filed with the China National Intellectual Property Administration on September 30, 2024 and entitled "BACK CONTACT SOLAR CELL AND MANUFACTURING METHOD THEREOF, AND PHOTOVOLTAIC MODULE", and Chinese Patent Application No. 202520025111.1, filed with the China National Intellectual Property Administration on January 6, 2025 and entitled "BACK CONTACT SOLAR CELL AND PHOTOVOLTAIC MODULE", which are incorporated herein by reference in their entireties.

### TECHNICAL FIELD

The present application relates to the technical field of photovoltaic modules, and in particular, to a back contact solar cell and a manufacturing method thereof, and a photovoltaic module.

### BACKGROUND

A back contact solar cell is a solar cell in which no electrode is arranged on a light receiving surface of a cell and positive and negative electrodes are all arranged on a back surface of the cell, so that blocking of the electrodes to the cell can be reduced, a short-circuit current of the cell can be increased, and the energy conversion efficiency of the cell can be improved

In an actual use process of the back contact solar cell, a blocking object such as bird droppings, leaves, or dust may fall on the back contact solar cell, and a temperature of the cell may be increased after being blocked to generate a hot spot effect. If a temperature generated by a hot spot exceeds a specific temperature value, problems such as delamination of a photovoltaic module, burning of a back panel, and crack of glass may be caused, leading to scrapping of the whole solar cell or even leading to a risk of fire hazard in severe cases.

### SUMMARY

An objective of the present application is to provide a back contact solar cell and a manufacturing method of, and a photovoltaic module.

To implement the foregoing objective, according to a first aspect, the present application provides a back contact solar cell. The back contact solar cell includes: a semiconductor substrate, a first doped semiconductor layer, a second doped semiconductor layer, and a transparent conductive layer. A conductivity type of the second doped semiconductor layer is opposite to a conductivity type of the first doped semiconductor layer. The semiconductor substrate includes a first surface and a second surface opposite to the first surface. The first surface includes first regions and second regions that are alternately arranged at intervals, and third regions located between the first regions and the second regions. In addition, the first regions, the third regions, and the second regions are distributed along a first direction. The first doped semiconductor layer is arranged on the first regions and the third regions. The second doped semiconductor layer is arranged on the second regions and extends to cover at least a part of the first doped semiconductor layer on the third regions. The transparent conductive layer covers the second doped semiconductor layer and the first doped semiconductor layer. An insulating groove is provided in the transparent conductive layer, to physically insulate a part of the transparent conductive layer corresponding to the first regions from a part of the transparent conductive layer corresponding to the second regions; or the transparent conductive layer only covers the second doped semiconductor layer. The second doped semiconductor layer includes a reverse leakage part, where the reverse leakage part is electrically connected to the first doped semiconductor layer, and the reverse leakage part is covered by the transparent conductive layer extending from the second region.

According to a second aspect, the present application provides a photovoltaic module, and the photovoltaic module includes the back contact solar cell according to the first aspect and various implementations of the first aspect.

According to a third aspect, the present application provides a manufacturing method of a back contact solar cell. The manufacturing method of a back contact solar cell includes: providing a semiconductor substrate, where the semiconductor substrate includes a first surface and a second surface opposite to the first surface, where the first surface includes first regions and second regions, and third regions located between the first regions and the second regions; and the first regions, the third regions, and the second regions are distributed along a first direction; forming a first doped semiconductor layer arranged on the first regions and the third regions; forming a second doped semiconductor layer that is arranged on the second regions and extends to cover a part of the first doped semiconductor layer that is on a side facing away from the semiconductor substrate and corresponds to the third regions, where a conductivity type of the second doped semiconductor layer is opposite to a conductivity type of the first doped semiconductor layer; and forming a transparent conductive layer, where the transparent conductive layer covers the second doped semiconductor layer and the first doped semiconductor layer, where an insulating groove is provided in the transparent conductive layer, to separate a part of the transparent conductive layer corresponding to the first regions from a part of the transparent conductive layer corresponding to the second regions; or the transparent conductive layer only covers the second doped semiconductor layer. The second doped semiconductor layer includes a reverse leakage part, where the reverse leakage part is electrically connected to the first doped semiconductor layer, and the reverse leakage part is covered by the transparent conductive layer extending from the second region.

### BRIEF DESCRIPTION OF THE DRAWINGS

The accompanying drawings described herein are used to provide a further understanding of the present application, and form a part of the present application. Exemplary embodiments of the present application and descriptions thereof are used to explain the present application, and do not constitute any inappropriate limitation to the present application. In the accompanying drawings:
FIG. 1 to FIG. 4 are respectively first, second, third, and fourth schematic longitudinal cross-sectional views of a structure of a back contact solar cell according to embodiments of the present application;
FIG. 5 to FIG. 7 are respectively first, second, and third schematic top views of a structure of a back contact solar cell according to embodiments of the present application on a side of a first surface;
FIG. 8 to FIG. 20 are schematic structural diagrams of a structure of a back contact solar cell during manufacturing according to embodiments of the present application;
FIG. 21 to FIG. 24 are respectively fifth, sixth, seventh, and eighth schematic longitudinal cross-sectional views of a structure of a back contact solar cell according to embodiments of the present application;
FIG. 25 to FIG. 30 are respectively fourth, fifth, sixth, seventh, eighth, and ninth schematic top views of a structure of a back contact solar cell according to embodiments of the present application;
FIG. 31 is a schematic diagram of a back contact solar cell according to an embodiment of the present application;
FIG. 32 is a partial cross-sectional view of a region C in FIG. 31;
FIG. 33 is a partial cross-sectional view of a region D in FIG. 31;
FIG. 34 is a schematic diagram of another back contact solar cell according to an embodiment of the present application; and
FIG. 35 is a ninth longitudinal cross-sectional view of a structure of a back contact solar cell according to an embodiment of the present application.

List of reference numerals: 11-Semiconductor substrate, 12-First doped semiconductor layer, 13-Second doped semiconductor layer, 14-Transparent conductive layer, 15-First region, 16-Second region, 17-Third region, 18-Insulating groove, 19-First transparent conductive portion, 20-Second transparent conductive portion, 21-Continuous region, 22-Discontinuous region, 23-Third transparent conductive portion, 24-Notch, 25-First electrode, 26-First interface passivation layer, 27-Second interface passivation layer, 28-Surface passivation layer, 29-Second electrode, 30-Insulating mask layer, 118-Reverse leakage part, 119-Corner region, 210-First insulating layer, 108-First side line, 109-Concave portion, 200-Convex portion, 3-Leakage channel, 4-Isolation portion, 103-Anti-reflection layer, 134-Central region, 135-Edge region, and 136-Reverse leakage region.

### DETAILED DESCRIPTION

Embodiments of the present application are described below with reference to the accompanying drawings. However, it should be understood that descriptions are merely examples, and are not intended to limit the scope of the present application. In addition, descriptions of well-known structures and technologies are omitted in the following descriptions, to avoid unnecessarily obscuring the concept of the present application.

The accompanying drawings show various schematic structural diagrams according to the embodiments of the present application. The figures are not drawn to scale, and for the purpose of clear expression, some details are enlarged, and some details may be omitted. Shapes of various regions and layers and relative sizes and position relationships between the regions and layers shown in the figures are merely examples. In practice, there may be a deviation due to a manufacturing tolerance or a technical limitation, and a person skilled in the art may additionally design regions/layers having different shapes, sizes, and relative positions according to actual requirements.

In the context of the present application, when a layer/element is referred to as being "above" another layer/element, the layer/element may be directly above the another layer/element, or a middle layer/element may exist therebetween. In addition, if a layer/element is "above" another layer/element in an orientation, the layer/element may be "below" the another layer/element when the orientation is reversed. To make the technical problems to be resolved by, the technical solutions, and the beneficial effects of the present application clearer and more comprehensible, the following further describes the present application in detail with reference to the accompanying drawings and the embodiments. It should be understood that the specific embodiments described herein are merely used for explaining the present application, but are not intended to limit the present application.

In addition, the terms "first" and "second" are used merely for the purpose of description, and shall not be construed as indicating or implying relative importance or implicitly indicating a quantity of indicated technical features. Therefore, a feature defined by "first" or "second" may explicitly or implicitly include one or more of such features. In the descriptions of the present application, "a plurality of' means two or more, unless otherwise clearly and specifically limited. Unless otherwise clearly and specifically limited, "at least one" means one or more than one.

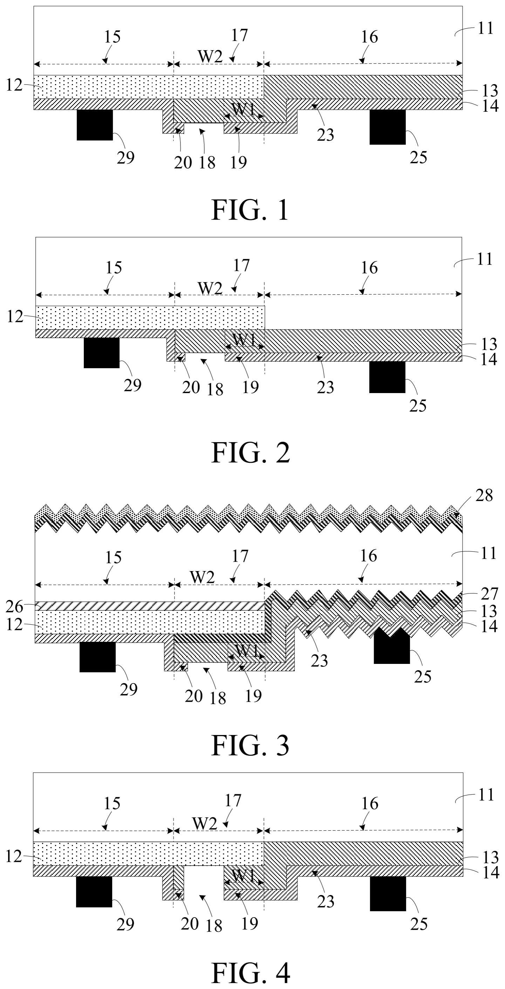

According to a first aspect, an embodiment of the present application provides a back contact solar cell. As shown in FIG. 1, the back contact solar cell according to this embodiment of the present application includes: a semiconductor substrate 11, a first doped semiconductor layer 12, a second doped semiconductor layer 13, and a transparent conductive layer 14. A conductivity type of the second doped semiconductor layer 13 is opposite to a conductivity type of the first doped semiconductor layer 12. The semiconductor substrate 11 includes a first surface and a second surface opposite to the first surface. The first surface includes first regions 15 and second regions 16, and third regions 17 located between the first regions 15 and the second regions 16. In addition, the first regions 15, the third regions 17, and the second regions 16 are distributed along a first direction. The first doped semiconductor layer 12 is arranged on the first regions 15 and the third regions 17. The second doped semiconductor layer 13 is arranged on the second regions 16 and extends to cover the first doped semiconductor layer 12 on the third regions 17.

The transparent conductive layer 14 covers the second doped semiconductor layer 13 and the first doped semiconductor layer 12. An insulating groove 18 is provided in the transparent conductive layer 14, to physically insulate a part of the transparent conductive layer 14 corresponding to the first regions 15 from a part of the transparent conductive layer 14 corresponding to the second regions 16. Certainly, it may be understood that, the transparent conductive layer may alternatively only cover the second doped semiconductor layer. In other words, the transparent conductive layer is not arranged on the first doped semiconductor layer.

In an actual application process, a material and a conductivity type of the semiconductor substrate are not specifically limited in the embodiments of the present application. For example, the semiconductor substrate may be a silicon substrate. Alternatively, the semiconductor substrate may be a substrate of any semiconductor material, such as a silicon-germanium substrate, a germanium substrate, or a gallium arsenide substrate.

In addition, the semiconductor substrate includes a first surface and a second surface opposite to the first surface, where the first surface of the semiconductor substrate corresponds to a back surface of the back contact solar cell, and the second surface of the semiconductor substrate corresponds to a light receiving surface of the back contact solar cell. The first surface includes first regions, second regions, and third regions, and distribution of the first regions, the second regions, and the third regions in the first surface may be determined according to distribution of the first doped semiconductor layer and the second doped semiconductor layer that are formed on a side of the first surface. Specifically, since the first doped semiconductor layer included in the back contact solar cell is arranged on the first regions and the third regions, distribution ranges of the first regions and the third regions in the first surface may be determined according to a requirement on distribution of the first doped semiconductor layer in an actual application scenario. Since a partial region of the second doped semiconductor layer included in the back contact solar cell is arranged on the second regions of the first surface, a distribution range of the second regions in the first surface may be determined according to a requirement on distribution of the second doped semiconductor layer on the semiconductor substrate in an actual application scenario.

It may be understood that, the first region corresponds to a first emitter region, and the second region corresponds to a second emitter region; and one of the first region and the second region is a P-type region, the other is an N-type region, and the third region is a PN overlapped region.

For example, the first regions and the second regions may be alternately spaced in a strip shape, or may be alternately spaced in an interdigitated shape.

A distribution direction (that is, the first direction) of the first regions, the third regions, and the second regions may be determined according to distribution of the first regions, the second regions, and the third regions in the first surface, which is not specifically limited herein. For example, when the first regions and the second regions are alternately spaced in the strip shape, the first direction is parallel to an arrangement direction of two types of adjacent strip-shaped regions. For another example, when the first regions and the second regions are alternately spaced in the interdigitated shape, the first direction parallel to an arrangement direction of two types of adjacent comb-shaped regions.

In terms of surface morphologies, as shown in FIG. 1 and FIG. 2, both the first surface and the second surface of the semiconductor substrate 11 may be planes. Alternatively, as shown in FIG. 3, the second surface of the semiconductor substrate 11 may be a textured surface, to improve a light-trapping effect of the second surface, thereby improving utilization on light by the semiconductor substrate 11. A surface of the second regions of the first surface may also be a textured surface, to increase a contact area between the second doped semiconductor layer 13 on the second regions and the transparent conductive layer 14 on the second regions, and increase a contact area between the transparent conductive layer 14 on the second regions and corresponding electrodes, thereby reducing a transmission loss.

For the first doped semiconductor layer, in terms of conductivity types, the conductivity type of the first doped semiconductor layer is not specifically limited in the embodiments of the present application, provided that the conductivity type of the first doped semiconductor layer is opposite to the conductivity type of the second doped semiconductor layer. Specifically, the conductivity type of the first doped semiconductor layer may be N-type, and the conductivity type of the second doped semiconductor layer is P-type in this case; or the conductivity type of the first doped semiconductor layer may alternatively be P-type, and the conductivity type of the second doped semiconductor layer is N-type in this case.

In terms of forming positions, as shown in FIG. 1, the first doped semiconductor layer 12 may be arranged on the first regions 15 and the third regions 17 of the semiconductor substrate; or as shown in FIG. 2, the first doped semiconductor layer 12 may alternatively be arranged in the first regions 15 and the third regions 17 of the semiconductor substrate. In this case, the first doped semiconductor layer may be formed through diffusion or ion injection.

When the first doped semiconductor layer is arranged on the first regions and the third regions of the semiconductor substrate, a material of the first doped semiconductor layer may include any semiconductor material such as silicon, silicon germanium, germanium, or gallium arsenide. In terms of arrangement of substances, a crystalline phase of the first doped semiconductor layer may be an amorphous semiconductor layer, a microcrystalline semiconductor layer, a nanocrystalline semiconductor layer, a monocrystalline semiconductor layer, or a polycrystalline semiconductor layer.

In a specific implementation, at least a part of the third region 17 is a reverse leakage region. In addition, in the reverse leakage region, a part of the transparent conductive layer 14 extending from the second region 16 into the third region 17 is a first transparent conductive portion 19, and the first transparent conductive portion 19 is electrically connected to the first doped semiconductor layer 12 through the second doped semiconductor layer 13. A width of the first transparent conductive portion 19 along the first direction is W1, a width of the third region 17 along the first direction is W2, and a ratio of W1 to W2 is greater than or equal to 10% and less than or equal to 90%.

In a case that the foregoing technical solution is used, in a case that the back contact solar cell is in an operating state, the first doped semiconductor layer and the second doped semiconductor layer can effectively diverge carriers, which is conducive to forming a photocurrent. The transparent conductive layer covering the second doped semiconductor layer and the first doped semiconductor layer has a high conductivity, so that carriers collected by the first doped semiconductor layer and the second doped semiconductor layer may be exported in time, thereby reducing a carrier recombination rate. As shown in FIG. 1, the second doped semiconductor layer 13 is not only arranged on the second regions 16 but also extends to cover the first doped semiconductor layer 12 on the third regions 17. In addition, at least a part of the third region 17 is a reverse leakage region. In the reverse leakage region, a part of the transparent conductive layer 14 extending from the second region 16 into the third region 17 (that is, the first transparent conductive portion 19) can be electrically connected to the first doped semiconductor layer 12 having an opposite conductivity type through the second doped semiconductor layer 13. In this case, an overlapped part of the first doped semiconductor layer 12 and the second doped semiconductor layer 13 forms a built-in diode structure having a low reverse breakdown voltage, and when the back contact solar cell is blocked, a leakage current (It should be noted that, for convenient and clear descriptions, when a transmission manner of the leakage current in the embodiments of the present application is mentioned, not only a transmission path of the leakage current is included, but also a transmission direction of the leakage current is included. However, it does not represent that the transmission direction of the leakage current may only be a single direction described herein, and when the conductivity types of the first doped semiconductor layer and the second doped semiconductor layer change, the transmission direction of the leakage current may also be opposite to the direction described herein. That is, in the embodiments of the present application, only the transmission path of the leakage current is limited, but the transmission direction of the leakage current is not limited) passes through the overlapped part of the first doped semiconductor layer 12 and the second doped semiconductor layer 13 and the first transparent conductive portion 19, and is exported through electrodes that are in contact with the back contact solar cell. It should be noted that, in the reverse leakage region, the first transparent conductive portion is electrically connected to the first doped semiconductor layer having an opposite conductivity type through the second doped semiconductor layer, and the electrical connection manner does not include an electrical connection implemented through the semiconductor substrate. In the back contact solar cell provided in the present application, the insulating groove provided in the transparent conductive layer may physically insulate the part of the transparent conductive layer corresponding to the first regions from the part of the transparent conductive layer corresponding to the second regions, where the physical insulation refers to being not in contact, to prevent the back contact solar cell from encountering a short circuit problem.

In addition, in the back contact solar cell provided in this embodiment of the present application, there is no need to arrange the insulating layer configured to separate the first doped semiconductor layer and the second doped semiconductor layer on the overlapped part of the first doped semiconductor layer and the second doped semiconductor layer 13, so that an electrical connection between the two semiconductor layers in the reverse leakage region is exactly utilized to reduce a hot spot risk while a manufacturing process of the back contact solar cell is simplified. In addition, along the first direction, a larger width of the first transparent conductive portion arranged in the reverse leakage region indicates smaller transmission resistance of the leakage current in the first transparent conductive portion, a larger decreasing degree of the corresponding reverse breakdown voltage, and a higher leakage loss of the back contact solar cell in a forward voltage region. On the contrary, along the first direction, a smaller width of the first transparent conductive portion arranged in the reverse leakage region indicates larger transmission resistance of the leakage current in the first transparent conductive portion, a smaller decreasing degree of the corresponding reverse breakdown voltage, and a lower leakage loss of the back contact solar cell in the forward voltage region. Based on this, in an application process of the back contact solar cell provided in the present application, only the width W1 of the first transparent conductive portion 19 along the first direction and the width W2 of the third region 17 along the first direction need to be adjusted, to adjust the leakage loss and the reverse breakdown voltage, so that the back contact solar cell has high operating efficiency in the forward voltage region while the hot spot risk of the back contact solar cell can be reduced. In addition, in an actual manufacturing process, only fine adjustment needs to be performed on a selectively etched pattern applied for forming the transparent conductive layer 14, and there is no need to change other manufacturing processes of the back contact solar cell, so that the compatibility of the back contact solar cell provided in this embodiment of the present application with existing manufacturing processes is improved, and the manufacturing difficulty of the back contact solar cell provided in this embodiment of the present application is reduced.

As shown in FIG. 1, the first doped semiconductor layer 12 may be directly arranged on the first regions 15 and the third regions 17. Alternatively, as shown in FIG. 3, the back contact solar cell may further include a first interface passivation layer 26 located between the first doped semiconductor layer 12 and the semiconductor substrate 11. In this case, a passivation contact structure formed by the first interface passivation layer 26 and the first doped semiconductor layer 12 has an excellent interface passivation effect, and carriers can be selectively collected, thereby reducing a carrier recombination rate in the first regions 15 and the third regions 17 of the first surface of the semiconductor substrate 11, and further improving the photoelectric conversion efficiency of the back contact solar cell. A material and a thickness of the first interface passivation layer 26 may be set according to the material of the first doped semiconductor layer 12 and an actual requirement, which are not specifically limited herein. For example, when the material of the first doped semiconductor layer is doped polysilicon, the first interface passivation layer is a tunneling passivation layer. For another example, when the material of the first doped semiconductor layer includes at least one of doped amorphous silicon, doped microcrystalline silicon, and doped nanocrystalline silicon, the first interface passivation layer is an intrinsic amorphous silicon layer, an intrinsic microcrystalline silicon layer, an intrinsic nanocrystalline silicon layer, or a mixed layer of the foregoing three layers.

For example, a thickness of the first doped semiconductor layer may be greater than or equal to 50 nm and less than or equal to 200 nm. For example, the thickness of the first doped semiconductor layer may be 50 nm, 60 nm, 70 nm, 80 nm, 90 nm, 100 nm, 110 nm, 120 nm, 150 nm, 180 nm, or 200 nm. In this case, when the thickness of the first doped semiconductor layer falls within the foregoing range, a low field passivation effect of the first doped semiconductor layer caused by a small layer thickness of the first doped semiconductor layer may be prevented; and a large use amount of consumables for manufacturing the first doped semiconductor layer caused by a large thickness of the first doped semiconductor layer may also be prevented, which is conducive to controlling manufacturing costs of the back contact solar cell. In addition, the thickness of the first doped semiconductor layer affects a docking height between a side surface of the first doped semiconductor layer and a side surface of the second doped semiconductor layer, and further affects a junction area of a PN junction formed between the first doped semiconductor layer and the second doped semiconductor layer in the reverse leakage region. Based on this, when the thickness of the first doped semiconductor layer falls within the foregoing range, a large leakage current at a docking part between the side surface of the first doped semiconductor layer and the side surface of the second doped semiconductor layer caused by a large docking height due to a large thickness of the first doped semiconductor layer may also be prevented, thereby ensuring that the leakage loss and the reverse breakdown voltage of the back contact solar cell can be effectively regulated by adjusting the width W1 of the first transparent conductive portion along the first direction and the width W2 of the third region along the first direction, so that the back contact solar cell has high operating performance and operating reliability.

For example, a doping concentration of a dopant in the first doped semiconductor layer may be greater than or equal to 1E19 cm⁻³ and less than or equal to 5E20 cm⁻³. For example, the doping concentration of the dopant in the first doped semiconductor layer may be 1E19 cm⁻³, 2E19 cm⁻³, 4E19 cm⁻³, 6E19 cm⁻³, 8E19 cm⁻³, 1E20 cm⁻³, 3E20 cm⁻³, or 5E20 cm⁻³. In this case, the doping concentration of the dopant in the first doped semiconductor layer falls within the foregoing range, so that a low field passivation effect of the first doped semiconductor layer on the semiconductor substrate caused by a low doping concentration of the dopant in the first doped semiconductor layer may be prevented, thereby ensuring that the first regions and the third regions have a relatively low carrier recombination rate in a case that the back contact solar cell operates normally. In addition, the first doped semiconductor layer also has good electrical conduction, thereby ensuring that a part of the first doped semiconductor layer in the reverse leakage region has relatively low transmission resistance when the back contact solar cell is blocked, which is further conducive to reducing the reverse breakdown voltage of the back contact solar cell. In addition, high difficulty in performing doping treatment on an intrinsic semiconductor layer for manufacturing the first doped semiconductor layer caused by a high doping concentration of the dopant in the first doped semiconductor layer may also be prevented, thereby reducing process difficulty and facilitating improving a yield of the back contact solar cell.

For the second doped semiconductor layer, in terms of materials, a material of the second doped semiconductor layer may include any semiconductor material such as silicon, silicon germanium, germanium, or gallium arsenide. In terms of arrangement of substances, a crystalline phase of the second doped semiconductor layer may be an amorphous semiconductor layer, a microcrystalline semiconductor layer, a nanocrystalline semiconductor layer, a monocrystalline semiconductor layer, or a polycrystalline semiconductor layer. A specific value of a crystallization rate of the second doped semiconductor layer may be determined according to an actual application scenario, which is not specifically limited herein.

For example, the crystallization rate of the second doped semiconductor layer may be less than or equal to 60%. For example, the crystallization rate of the second doped semiconductor layer may be 0, 5%, 10%, 20%, 30%, 40%, 50%, or 60%. In this case, it may be understood that, the crystallization rate of the second doped semiconductor layer affects the electrical conduction of the second doped semiconductor layer, and further affects the leakage loss of the back contact solar cell in the reverse leakage region and the reverse breakdown voltage when the back contact solar cell is blocked. Based on this, when the crystallization rate of the second doped semiconductor layer falls within the foregoing range, the crystallization rate of the second doped semiconductor layer has a large optional range. In this case, in addition to adjusting the range of the ratio of W1 to W2 to regulate the leakage loss and the reverse breakdown voltage of the back contact solar cell, the leakage loss and the reverse breakdown voltage of the back contact solar cell may further be precisely regulated by adjusting the crystallization rate of the second doped semiconductor layer, thereby ensuring that the back contact solar cell has high operating performance and operating reliability.

In terms of conductivities, a conductivity of the second doped semiconductor layer directly affects the electrical conduction of the second doped semiconductor layer. The electrical conduction of the second doped semiconductor layer affects the leakage loss of the back contact solar cell in the reverse leakage region and the reverse breakdown voltage when the back contact solar cell is blocked. Based on this, a suitable conductivity between a first electrode 25 and the second doped semiconductor layer 13 may be selected according to requirements on the leakage loss and the reverse breakdown voltage in an actual application scenario.

For example, the conductivity of the second doped semiconductor layer is greater than or equal to 10E-5 S/cm and less than or equal to 1 S/cm. In this case, a large forward leakage loss of the back contact solar cell caused by excessively high electrical conduction of the second doped semiconductor layer due to a large conductivity of the second doped semiconductor layer may be prevented; and a high reverse breakdown voltage of the back contact solar cell caused by excessively low electrical conduction of the second doped semiconductor layer due to a small conductivity of the second doped semiconductor layer may also be prevented, which is further conducive to balancing the reverse breakdown voltage and the operating efficiency corresponding to the back contact solar cell.

In an actual application process, conductive characteristics of different parts of the second doped semiconductor layer may be the same or may be different.

It may be understood that, when the back contact solar cell is in a normal operating state, a part of the second doped semiconductor layer located in the second regions needs to collect and export carriers of a corresponding conductivity type generated in the semiconductor substrate, which is conducive to forming a photocurrent. A part of the second doped semiconductor layer corresponding to the first transparent conductive portion is electrically connected to the first doped semiconductor layer having an opposite conductivity type (to reduce a hot spot risk of the back contact solar cell), and when the back contact solar cell is in the normal operating state, a leakage current exists between the part of the second doped semiconductor layer corresponding to the first transparent conductive portion and the first doped semiconductor layer. As can be learned from the foregoing content, parts of the second doped semiconductor layer located in different regions have different functions. In a case that other factors are the same, a smaller crystallization degree of the doped semiconductor layer indicates smaller grains and/or a smaller quantity of grains in the doped semiconductor layer, and even the randomness of an amorphous silicon semiconductor material is presented. Smaller grains and/or a smaller quantity of grains in the doped semiconductor layer indicates more interfaces between the grains in the doped semiconductor layer, leading to large resistance at an interface between the grains. As can be seen, crystallization degrees of the parts of the second doped semiconductor layer located in different regions affect the conductive characteristics of the parts. Therefore, the conductive characteristics and the crystallization degrees of different parts of the second doped semiconductor layer may be determined according to the functions of the parts of the second doped semiconductor layer located in different regions and requirements on the conversion efficiency and a hot spot risk of the back contact solar cell.

For example, a crystallization degree of at least a part of the second doped semiconductor layer located in the second regions may be greater than a crystallization degree of a part of the second doped semiconductor layer corresponding to the first transparent conductive portion.

It should be noted that, a larger crystallization degree indicated in this embodiment of the present application may be a larger crystallization rate, a larger grain size, and/or a larger quantity of grains. For example, when the second doped semiconductor layer is a nanocrystalline silicon layer (the nanocrystalline silicon layer generally may still contain a part of an amorphous silicon portion inside, this is inevitable, and content of the amorphous silicon portion is few, which is well-known in the art), the crystallization degree of at least the part of the second doped semiconductor layer located in the second regions is larger, and the part has a larger crystallization rate and a large grain size than those of the part of the second doped semiconductor layer corresponding to the first transparent conductive portion. For another example, when the second doped semiconductor layer is an amorphous silicon layer (the amorphous silicon may contain a few nanocrystalline silicon portion, but content of the nanocrystalline silicon portion is quite small, for example, less than 5%, which is well-known in the art), grains with an ordered crystal lattice may be generated in at least the part of the second doped semiconductor layer located in the second regions, so that the crystallization degree of the part is increased. The crystallization degree of the part of the second doped semiconductor layer corresponding to the first transparent conductive portion is smaller. In this case, the part with a small crystallization degree is still made of amorphous silicon materials and does not contain grains generated after treatment such as laser treatment. In this case, a conductivity of at least the part of the second doped semiconductor layer located in the second regions is larger, which is conducive to reducing a transmission loss of at least the part of the second doped semiconductor layer located in the second regions and reducing contact resistance between at least the part of the second doped semiconductor layer located in the second regions and the transparent conductive layer. The crystallization degree of the part of the second doped semiconductor layer corresponding to the first transparent conductive portion is small. In this case, a conductivity of the part of the second doped semiconductor layer corresponding to the first transparent conductive portion is relatively low, which is conducive to reducing a magnitude of a forward leakage current between the part of the second doped semiconductor layer corresponding to the first transparent conductive portion and the first doped semiconductor layer, thereby further improving the conversion efficiency of the back contact solar cell.

In terms of ranges, a crystallization degree of a part of the second doped semiconductor layer located in only a partial range of the second region may be relatively large, or a crystallization degree of a part of the second doped semiconductor layer located in the whole range of the second region may be large. A range of the part having a large crystallization degree in the second doped semiconductor layer may be determined according to a manner for enabling different regions of the second doped semiconductor layer to have different crystallization degrees used in an actual manufacturing process and actual manufacturing precision, which is not specifically limited herein.

The crystallization degree of at least the part of the second doped semiconductor layer located in the second regions may be only greater than the crystallization degree of the part of second doped semiconductor layer corresponding to the first transparent conductive portion. Alternatively, the crystallization degree of at least the part of the second doped semiconductor layer located in the second regions may be greater than a crystallization degree of a part of the second doped semiconductor layer located in the third regions. Alternatively, the crystallization degree of at least the part of the second doped semiconductor layer located in the second regions may be not only greater than the crystallization degree of the part of the second doped semiconductor layer corresponding to the first transparent conductive portion but also greater than a crystallization degree of a part of the second doped semiconductor layer covering a side wall, where the side wall is located at a junction of the third region and the second region. In this case, it may be understood that, in the second doped semiconductor layer, compared with the part corresponding to the second regions, the part located on the side wall at the junction of the third region and the second region is closer to the second region. Based on this, when the crystallization degree of the part of the second doped semiconductor layer covering the side wall at the junction of the third region and the second region is relatively small, the part of the second doped semiconductor layer at least corresponding to the first transparent conductive portion is prevented from being also affected when crystallization modification is performed on at least the part of the second doped semiconductor layer corresponding to the second regions in a laser treatment manner in an actual manufacturing process, thereby ensuring that the part of the second doped semiconductor layer at least corresponding to the first transparent conductive portion has a relatively small conductivity and effectively controlling the magnitude of the forward leakage current between the part of the second doped semiconductor layer corresponding to the first transparent conductive portion and the first doped semiconductor layer.

In addition, it may be understood that, a larger crystallization degree of at least the part of the second doped semiconductor layer located in the second regions indicates a larger conductivity of the part. A smaller crystallization degree of the part of the second doped semiconductor layer corresponding to the first transparent conductive portion indicates a smaller conductivity of the part. In this case, the conversion efficiency of the back contact solar cell is relatively high, and a decreasing degree of the hot spot risk is also affected. Therefore, a difference between the crystallization degree of at least the part of the second doped semiconductor layer located in the second regions and the crystallization degree of the part of the second doped semiconductor layer corresponding to the first transparent conductive portion may be determined according to requirements on the conversion efficiency and the hot spot risk of the back contact solar cell in an actual application scenario, which is not specifically limited herein.

For example, the difference between the crystallization rate of at least the part of the second doped semiconductor layer located in the second regions and the crystallization rate of the part of the second doped semiconductor layer corresponding to the first transparent conductive portion may be greater than or equal to 40% and less than or equal to 80%. For example, the difference between the crystallization rate of at least the part of the second doped semiconductor layer located in the second regions and the crystallization rate of the part of the second doped semiconductor layer corresponding to the first transparent conductive portion may be 40%, 42%, 45%, 50%, 55%, 60%, 65%, 70%, 75%, or 80%. In this case, when the difference falls within the foregoing range, poor carrier collection efficiency of the part caused by a small crystallization degree of at least the part of the second doped semiconductor layer located in the second regions and/or a large forward leakage current corresponding to the part caused by a high crystallization degree of the part of the second doped semiconductor layer corresponding to the first transparent conductive portion due to a small difference may be prevented, thereby ensuring that the back contact solar cell has high conversion efficiency. In addition, a high hot spot risk of the back contact solar cell caused by a small crystallization degree of the part of the second doped semiconductor layer corresponding to the first transparent conductive portion due to a large difference may also be prevented, thereby ensuring that the back contact solar cell has high anti-burning capability.

In an actual application process, the second doped semiconductor layer may further include a high crystallization region and a low crystallization region, where a crystallization degree of a part of the second doped semiconductor layer located in the low crystallization region is less than a crystallization degree of a part of the second doped semiconductor layer located in the high crystallization region. Based on this, in the second doped semiconductor layer, a part at least corresponding to the first transparent conductive portion is located in the low crystallization region, and at least a part corresponding to the second region is located in the high crystallization region. Application principles of beneficial effects in this case are similar to application principles of beneficial effects when the crystallization degree of at least the part of the second doped semiconductor layer located in the second region is greater than the crystallization degree of the part of the second doped semiconductor layer corresponding to the first transparent conductive portion.

In terms of ranges, ranges of the high crystallization region and the low crystallization region in the second doped semiconductor layer may be determined according to a manner for enabling different regions of the second doped semiconductor layer to have different crystallization degrees used in an actual manufacturing process and actual manufacturing precision, which are not specifically limited herein.

Specifically, the low crystallization region may be located in the third region. In this case, the low crystallization region of the second doped semiconductor layer may only correspond to the part the of the second doped semiconductor layer corresponding to the first transparent conductive portion; or the low crystallization region corresponds to the whole third region. The high crystallization region of the second doped semiconductor layer may only correspond to a part of the second doped semiconductor layer located in a partial range of the second region; or the high crystallization region may correspond to the whole second region. Alternatively, the high crystallization region may not only correspond to at least the part of the second doped semiconductor layer located in the second region but also include the part of the second doped semiconductor layer located on the side wall at the junction of the second region and the third region.

Alternatively, along the first direction, a side edge of the low crystallization region is located in the third region, and the other side edge extends to a side wall, where the side wall is located at the junction of the third region and the second region. In this case, the high crystallization region of the second doped semiconductor layer may correspond to a part of the second doped semiconductor layer located in at least a partial range of the second region.

Alternatively, along the first direction, a side edge of the low crystallization region is located in the third region, and the other side edge extends to the second region. In this case, the part of the second doped semiconductor layer located in the high crystallization region only corresponds to a part of the second doped semiconductor layer located in a partial range of the second region.

In a case that the foregoing technical solution is used, at least a part of the third region is a reverse leakage region, so that when the low crystallization region is located in the third region, it may be ensured that a conductivity of a part of the second doped semiconductor layer located in the reverse leakage region is relatively small, and a magnitude of a forward leakage current between the second doped semiconductor layer and the first doped semiconductor layer in the reverse leakage region is effectively controlled, which is conducive to improving the conversion efficiency of the back contact solar cell. In addition, when a side edge of the low crystallization region is located in the third region and the other side edge extends to the side wall at the junction of the third region and the second region along the first direction, or when a side edge of the low crystallization region is located in the third region and the other side edge extends to the second region along the first direction, the foregoing operations may be prevented from affecting the part of the second doped semiconductor layer located in the third region while at least the part of the second doped semiconductor layer corresponding to the second region is located in the high crystallization region in a laser treatment manner, thereby reducing a requirement on processing process precision while ensuring that the part of the second doped semiconductor layer located in the third region has a small conductivity. In addition, when the high crystallization region corresponds to the whole second region, the part of the second doped semiconductor layer corresponding to the whole second region has a relatively high conductivity, so that the part of the second doped semiconductor layer corresponding to the whole second region has high carrier collection efficiency and the operating efficiency of the back contact solar cell is improved. In addition, division ranges of the low crystallization region and the high crystallization region in the second doped semiconductor layer have a plurality of instances, so that the applicability of the back contact solar cell according to the embodiments of the present application in different application scenarios may be improved while the process difficulty is reduced.

A difference between the crystallization degrees of the low crystallization region and the high crystallization region in the second doped semiconductor layer may be determined according to requirements on the conversion efficiency and a hot spot risk of the back contact solar cell in an actual application scenario. Specifically, reference may be made to the difference between the crystallization degree of at least the part of the second doped semiconductor layer located in the second region and the crystallization degree of the part of the second doped semiconductor layer corresponding to the first transparent conductive portion, and details are not described herein again.

In terms of doping, a doping concentration of a dopant in the second doped semiconductor layer is not specifically limited in the embodiments of the present application, provided that the second doped semiconductor layer can be used in the back contact solar cell according to the embodiments of the present application.

For example, the doping concentration of the dopant in the second doped semiconductor layer may be greater than or equal to 1E19 cm⁻³ and less than or equal to 5E20 cm⁻³. For example, the doping concentration of the dopant in the second doped semiconductor layer may be 1E19 cm⁻³, 2E19 cm⁻³, 4E19 cm⁻³, 6E19 cm⁻³, 8E19 cm⁻³, 1E20 cm⁻³, 3E20 cm⁻³, or 5E20 cm⁻³. In this case, the doping concentration of the dopant in the second doped semiconductor layer falls within the foregoing range, so that a low field passivation effect of the second doped semiconductor layer on the semiconductor substrate caused by a low doping concentration of the dopant in the second doped semiconductor layer may be prevented, thereby ensuring that the second region has a relatively low carrier recombination rate in a case that the back contact solar cell operates normally. In addition, the second doped semiconductor layer also has good electrical conduction, thereby ensuring that a part of the second doped semiconductor layer in the reverse leakage region has relatively low transmission resistance when the back contact solar cell is blocked, which is further conducive to reducing the reverse breakdown voltage of the back contact solar cell. In addition, high difficulty in performing doping treatment on an intrinsic semiconductor layer for manufacturing the second doped semiconductor layer caused by a high doping concentration of the dopant in the second doped semiconductor layer may also be prevented, thereby facilitating improving a yield of the back contact solar cell.

In terms of layer thicknesses, a thickness of the second doped semiconductor layer is not specifically limited in the embodiments of the present application. For example, the thickness of the second doped semiconductor layer may be greater than or equal to 5 nm and less than or equal to 50 nm. For example, the thickness of the second doped semiconductor layer may be 5 nm, 10 nm, 15 nm, 20 nm, 30 nm, 40 nm, or 50 nm. Application principles of beneficial effects in this case are similar to application principles of beneficial effects when the thickness of the first doped semiconductor layer is greater than or equal to 50 nm and less than or equal to 200 nm, and details are not described herein again.

In terms of forming positions, as shown in FIG. 1 and FIG. 2, the second doped semiconductor layer 13 may be directly arranged on the second regions 16 and extend to cover the first doped semiconductor layer 12 on the third regions 17. Alternatively, as shown in FIG. 3, the back contact solar cell may further include a second interface passivation layer 27, and the second interface passivation layer 27 is located between the second regions 16 of the first surface and the second doped semiconductor layer 13 and extends to a space between the second doped semiconductor layer and the first doped semiconductor layer. In this case, a passivation contact structure formed by the second interface passivation layer 27 and a part of the second doped semiconductor layer 13 located on the second regions 16 can selectively collect carriers, thereby reducing a carrier recombination rate in the second regions 16 of the first surface of the semiconductor substrate 11. A material and a thickness of the second interface passivation layer 27 may be set according to the material of the second doped semiconductor layer 13 and an actual requirement, which are not specifically limited herein. For example, when the material of the second doped semiconductor layer is doped polysilicon, the second interface passivation layer is a tunneling passivation layer. For another example, when the material of the second doped semiconductor layer includes doped amorphous silicon, doped microcrystalline silicon, and doped nanocrystalline silicon, the second interface passivation layer is an intrinsic amorphous silicon layer, an intrinsic microcrystalline silicon layer, an intrinsic nanocrystalline silicon layer, or a mixed layer of the foregoing three layers.

For the thickness of the second interface passivation layer, since the thickness of the second interface passivation layer affects transmission resistance and a passivation effect of the second interface passivation layer and further affects the forward leakage loss and the reverse breakdown voltage of the back contact solar cell. Therefore, in an actual application scenario, the thickness of the second interface passivation layer may be determined according to requirements on the forward leakage loss and the reverse breakdown voltage of the back contact solar cell, which is not specifically limited herein.

For example, the thickness of the second interface passivation layer may be greater than or equal to 2 nm and less than or equal to 20 nm. For example, the thickness of the second interface passivation layer may be 2 nm, 5 nm, 8 nm, 10 nm, 12 nm, 15 nm, 18 nm, or 20 nm. In this case, based on this, when the thickness of the second interface passivation layer falls within the foregoing range, a poor passivation effect of the second interface passivation layer on the second regions caused by a small thickness of the second interface passivation layer may be prevented, thereby ensuring a low carrier recombination rate on a surface of the second regions. In addition, low carrier collection efficiency of the second doped semiconductor layer when the back contact solar cell operates normally and a small decreasing degree of the reverse breakdown voltage when the back contact solar cell is blocked that are caused by large transmission resistance due to a large thickness of the second interface passivation layer may also be prevented, which is further conducive to balancing the reverse breakdown voltage and the operating efficiency corresponding to the back contact solar cell.

In addition, the doping concentration of the dopant in the second doped semiconductor layer affects the electrical conduction of the second doped semiconductor layer. Specifically, in a specific range, a higher doping concentration of the dopant in the second doped semiconductor layer indicates higher electrical conduction of the second doped semiconductor layer; and on the contrary, a lower doping concentration of the dopant in the second doped semiconductor layer indicates lower electrical conduction of the second doped semiconductor layer. For the second interface passivation layer, as described above, the thickness of the second interface passivation layer is related to the passivation effect and the transmission resistance of the second interface passivation layer, and a smaller thickness of the second interface passivation layer indicates a larger leakage current between the first doped semiconductor layer and the second doped semiconductor layer in the reverse leakage region. A larger thickness of the second interface passivation layer indicates a lower leakage loss of the back contact solar cell in the forward voltage region but larger transmission resistance of the second interface passivation layer. Based on this, a matching thickness of the second interface passivation layer may further be determined according to a range of the doping concentration of the dopant in the second doped semiconductor layer in an actual application scenario.

For example, when the doping concentration of the dopant in the second doped semiconductor layer is greater than or equal to 1E19 cm⁻³ and less than or equal to 5E19 cm⁻³, the thickness of the second interface passivation layer may be greater than or equal to 5 nm and less than or equal to 15 nm. For example, when the doping concentration of the dopant in the second doped semiconductor layer is greater than or equal to 1E19 cm⁻³ and less than or equal to 5E19 cm⁻³, the thickness of the second interface passivation layer may be 5 nm, 8 nm, 10 nm, 12 nm, 14 nm, or 15 nm.

Alternatively, when the doping concentration of the dopant in the second doped semiconductor layer is greater than 5E19 cm⁻³ and less than or equal to 1E20 cm⁻³, the thickness of the second interface passivation layer may be greater than or equal to 6 nm and less than or equal to 17 nm. For example, when the doping concentration of the dopant in the second doped semiconductor layer is greater than 5E19 cm⁻³ and less than or equal to 1E20 cm⁻³, the thickness of the second interface passivation layer may be 6 nm, 8 nm, 9 nm, 10 nm, 11 nm, 12 nm, 13 nm, 14 nm, 15 nm, 16 nm, or 17 nm.

Alternatively, when the doping concentration of the dopant in the second doped semiconductor layer is greater than 1E20 cm⁻³ and less than or equal to 5E20 cm⁻³, the thickness of the second interface passivation layer may be greater than or equal to 7 nm and less than or equal to 20 nm. For example, when the doping concentration of the dopant in the second doped semiconductor layer is greater than 1E20 cm⁻³ and less than or equal to 5E20 cm⁻³, the thickness of the second interface passivation layer may be 7 nm, 10 nm, 11 nm, 12 nm, 13 nm, 14 nm, 16 nm, 18 nm, or 20 nm.

It should be noted that, in the back contact solar cell according to the embodiments of the present application, second interface passivation layers with corresponding thicknesses are arranged according to different doping concentrations of the dopant in the second doped semiconductor layer, so that the operating efficiency and the reverse breakdown voltage of the back contact solar cell are properly regulated, thereby ensuring that the back contact solar cell has high operating performance and operating reliability.

In addition, in a case that the back contact solar cell includes the first interface passivation layer and the second interface passivation layer, the first interface passivation layer and the first doped semiconductor layer form a first passivation contact structure, and the second interface passivation layer and the second doped semiconductor layer form a second passivation contact structure.

A passivated contact type of the first passivation contact structure may be the same as a passivated contact type of the second passivation contact structure. For example, both the first passivation contact structure and the second passivation contact structure are tunneling passivation contact structures or heterogeneous contact structures. Alternatively, a passivated contact type of the first passivation contact structure may be different from a passivated contact type of the second passivation contact structure. For example, one of the first passivation contact structure and the second passivation contact structure is a tunneling passivation contact structure, and the other is a heterogeneous contact structure. In this case, when the passivated contact type of the first passivation contact structure is different from the passivated contact type of the second passivation contact structure, the passivated contact type of the first passivation contact structure and the passivated contact type of the second passivation contact structure may be respectively regulated according to different requirements in an actual application scenario, to improve the applicability of the back contact solar cell according to the embodiments of the present application in different application scenarios.

Thermal stability of the first passivation contact structure may be greater than thermal stability of the second passivation contact structure. In this case, in an actual manufacturing process, after the first passivation contact structure is formed in the first regions and the third regions and the second passivation contact structure that is entirely arranged is formed, patterning treatment generally needs to be performed on a mask material that is entirely arranged by using a laser treatment process, to form a mask layer for performing selective etching on the second passivation contact structure. Treatment is performed on each part of the mask material corresponding to the first regions, and heat for processing laser radiation is conducted to the first passivation contact structure. Since laser has high heat, when the first passivation contact structure has high thermal stability, influence of the heat radiated by the laser on the first passivation contact structure may be reduced, or even the first passivation contact structure is not affected by the heat radiated by the laser, thereby improving a yield of the back contact solar cell. Since a part of the second passivation contact structure corresponding to the first regions needs to be removed and the laser treatment process has high precision, parts of the second passivation contact structure corresponding to the third regions and the second regions are not affected by heat or are less affected by heat. In this case, the manufacturing process has a low requirement on the thermal stability of the second passivation contact structure, so that the thermal stability of the second passivation contact structure may be set to be lower than the thermal stability of the first passivation contact structure.

Certainly, the first passivation contact structure and the second passivation contact structure may alternatively have approximately the same thermal stability. Alternatively, in an actual manufacturing process, if the patterning treatment on the mask material is not implemented by using the laser treatment process and selective etching on the mask material and the second passivation contact structure is implemented by using another low-temperature process, the first passivation contact structure may also have relatively low thermal stability.

Specific types of the first passivation contact structure and the second passivation contact structure may be determined according to an actual requirement, which are not specifically limited herein.

For example, the first passivation contact structure may be a tunneling passivation contact structure. In this case, since an amorphous silicon material can easily form polysilicon or monocrystalline silicon at a high temperature and a tunneling passivation material and the polysilicon have relatively stable chemical properties at a high temperature, compared with a heterogeneous contact structure, the tunneling passivation contact structure has a small sensitivity degree to a thermal loss of high-temperature laser, so that influence on a passivation effect during the laser treatment process may be reduced, thereby further increasing a process window and reducing the process difficulty. In addition, in an actual manufacturing process, manufacturing costs of the heterogeneous contact structure are higher than manufacturing costs of the tunneling passivation contact structure. Besides, the tunneling passivation contact structure may be implemented by using a plurality of processes such as low pressure chemical vapor deposition, plasma chemical vapor deposition, physical chemical vapor deposition, or plasma-enhanced atomic layer deposition, so that the tunneling passivation contact structure is more likely to be compatible with a back contact solar cell process while the heterogeneous contact structure needs to be manufactured by using a plate-type plasma chemical vapor deposition device that supports a low formation temperature. Based on this, when the first passivation contact structure is a tunneling passivation contact structure, manufacturing costs can be reduced and investment of the plate-type plasma chemical vapor deposition device can be reduced, thereby reducing an area of a manufacturing site.

For example, the second passivation contact structure may be a heterogeneous contact structure. In this case, the heterogeneous contact structure has a passivation effect better than that of the tunneling passivation contact structure. Therefore, when the second passivation contact structure is a heterogeneous contact structure, a carrier recombination rate at an interface between the semiconductor substrate and the second interface passivation layer may be further reduced, which is conducive to improving the photoelectric conversion efficiency of the back contact solar cell. Specifically, a material of an intrinsic semiconductor passivation layer in the heterogeneous contact structure includes at least one of intrinsic amorphous silicon, intrinsic microcrystalline silicon, and intrinsic nanocrystalline silicon. A material of a doped semiconductor layer in the heterogeneous contact structure may include at least one of doped amorphous silicon, doped microcrystalline silicon, and doped nanocrystalline silicon.

It should be noted that, materials of passivation contact structures of different passivated contact types are different, and doped semiconductor materials of different conductivity types have different conductive characteristics. Therefore, a conductivity type of the first passivation contact structure and a conductivity type of the second passivation contact structure may be determined according to the passivated contact type of the first passivation contact structure and the passivated contact type of the second passivation contact structure.

In an embodiment, in a case that the first passivation contact structure is a tunneling passivation contact structure and the second passivation contact structure is a heterogeneous contact structure, the conductivity type of the first passivation contact structure is N-type, and the conductivity type of the second passivation contact structure is P-type. In this case, compared with a P-type doped amorphous silicon material or a P-type doped microcrystalline silicon material, contact resistance between a P-type polysilicon material and electrodes is high and a field passivation effect is poor. Therefore, when the conductivity type of the tunneling passivation contact structure is set to N-type and the conductivity type of the heterogeneous contact structure is set to P-type, the field passivation effect of the first tunneling passivation contact structure may be further improved, and the contact resistance between the first tunneling passivation contact structure and electrodes can be reduced, which is conducive to improving the electrical performance of the back contact solar cell.

For the foregoing transparent conductive layer, a material and a thickness of the transparent conductive layer are not specifically limited in the embodiments of the present application. For example, the material of the transparent conductive layer may include at least one of fluorine-doped tin oxide, aluminum-doped zinc oxide, tin-doped indium oxide, tungsten-doped indium oxide, molybdenum-doped indium oxide, cerium-doped indium oxide, and indium hydroxide.

For example, the thickness of the transparent conductive layer may be greater than or equal to 10 nm and less than or equal to 100 nm.

For the insulating groove provided in the transparent conductive layer, the insulating groove is configured to physically insulate the part of the transparent conductive layer corresponding to the first regions and the part of the transparent conductive layer corresponding to the second regions. Specifically, the part of the transparent conductive layer corresponding to the first regions is in Ohmic connection with a second electrode and the part of the transparent conductive layer corresponding to the second regions is in Ohmic connection with a first electrode, the two parts of the transparent conductive layer cannot be directly electrically connected. That is, the two parts of the transparent conductive layer need to be physically insulated, namely, be not in contact with each other. Based on this, it may be understood that, to prevent a short circuit, both ends of the insulating groove may be located in the third region, or an end along the first direction is located outside the third region (certainly, it may be understood that, the reverse leakage region is excluded because the transparent conductive layer needs to extend from the second region into the third region in the reverse leakage region).

In addition, as shown in FIG. 1 to FIG. 3, the insulating groove 18 may only penetrate the transparent conductive layer 14. Alternatively, as shown in FIG. 4, when the second doped semiconductor layer 13 has relatively low resistivity (for example, the resistivity of the second doped semiconductor layer 13 is less than or equal to 0.01 Ω·cm. Specifically, the second doped semiconductor layer 13 is a doped polysilicon layer and/or a doped monocrystalline silicon layer), the insulating groove 18 not only needs to penetrate the transparent conductive layer 14 but also needs to at least penetrate the second doped semiconductor layer 13, to prevent a short circuit caused by an electrical connection between the parts of the transparent conductive layer 14 corresponding to the first regions 15 and the second regions 16 through the second doped semiconductor layer 13 that is consecutively arranged in the third regions 17. In a case that the foregoing second interface passivation layer exists, generally, the second interface passivation layer does not need to be broken at the insulating groove. Certainly, in some processes, the second doped semiconductor layer 13 and the second interface passivation layer may alternatively be broken simultaneously under a same process operation.

For a width of the insulating groove along the first direction, a range of the width not only affects an electrical insulation effect between the parts of the transparent conductive layer corresponding to the first regions and the second regions but also affects a width of the first transparent conductive portion on the third regions along the first direction, further affecting the leakage loss and the reverse breakdown voltage of the back contact solar cell. Therefore, the width of the insulating groove along the first direction is set according to an actual requirement, provided that the ratio of the width W1 of the first transparent conductive portion along the first direction to the width W2 of the third region along the first direction is greater than or equal to 10% and less than or equal to 90%.

Specifically, the ratio of the width W1 of the first transparent conductive portion along the first direction to the width W2 of the third region along the first direction may be any value that is greater than or equal to 10% and less than or equal to 90%. For example, the ratio of W1 to W2 may be 10%, 20%, 30%, 40%, 50%, 60%, 70%, 80%, or 90%.

Cross-sectional areas of different regions of the insulating groove in a thickness direction of the semiconductor substrate may be the same. Alternatively, a cross-sectional area of the insulating groove gradually decreases along a direction approaching the semiconductor substrate. Specifically, when the cross-sectional area of the insulating groove gradually decreases in the direction approaching the semiconductor substrate, the cross-sectional area may gradually decrease in a linear manner or may gradually decrease in the shape of a parabola. Through such setting, a cross-sectional area of the insulating groove at a groove bottom is less than a cross-sectional area of the insulating groove at a groove opening, and a thickness of an end portion of the transparent conductive layer close to the insulating groove gradually increases along a direction away from the insulating groove. Based on this, especially for the reverse leakage region, the leakage current flows from an edge of the transparent conductive layer to corresponding electrodes. In this case, a density of leakage currents at the edge of the transparent conductive layer is small, and almost all leakage currents flow through a part of the transparent conductive layer away from an edge region, so that a density of leakage currents at the part of the transparent conductive layer away from the edge region is large. In the foregoing case, when the thickness of the end portion of the transparent conductive layer close to the insulating groove gradually increases in the direction away from the insulating groove, the part of the transparent conductive layer away from the edge region has a large thickness, which is more conducive to transmission of the leakage current and conducive to further reducing the hot spot risk of the back contact solar cell.

In addition, A region of the transparent conductive layer in which a orthographic projection of the transparent conductive layer on the first surface does not overlap with an orthographic projection of the insulating groove on the first surface, wherein the region has a uniform thickness along the first direction. In this case, each region along the first direction of the part of the transparent conductive layer away from the edge region has a large thickness, which is conducive to transmission of the leakage current when the back contact solar cell is blocked, and is also conducive to exporting a photocurrent generated by the back contact solar cell in the forward voltage region, thereby further improving the operating performance and reducing the hot spot risk of the back contact solar cell.

Alternatively, in the transparent conductive layer, thicknesses of regions that are along the first direction and that are of a part whose orthographic projection on the first surface does not overlap with an orthographic projection of the insulating groove on the first surface may be different. For example, when the first doped semiconductor layer and the second doped semiconductor layer have different electrical conduction, a thickness of the transparent conductive layer arranged on one having poor electrical conduction of the first doped semiconductor layer and the second doped semiconductor layer may be greater than a thickness of the transparent conductive layer arranged on the other.

As shown in FIG. 1 to FIG. 4, a part of the transparent conductive layer 14 extending from the first region 15 into the third region 17 is defined as a second transparent conductive portion 20. It may be understood that, under an isolation effect of the insulating groove 18, the leakage current only passes through the first doped semiconductor layer 12 in the reverse leakage region and is conducted through the second doped semiconductor layer 13 to the first transparent conductive portion 19 having a conductivity type opposite to that of the first doped semiconductor layer 12, so that existence of the second transparent conductive portion 20 has low influence or even no influence on the reverse breakdown voltage. However, the first transparent conductive portion 19, the second transparent conductive portion 20, and the insulating groove 18 are all provided in the third regions 17. To insulate the parts of the transparent conductive layer 14 corresponding to the first regions 15 and the second regions 16, the width of the insulating groove 18 along the first direction needs to be greater than or equal to a minimum leakage-proof gap. Based on this, a width of the second transparent conductive portion 20 along the first direction indirectly affects the leakage loss and the reverse breakdown voltage of the back contact solar cell, so that the width of the second transparent conductive portion 20 along the first direction may be set according to an actual requirement, which is not specifically limited herein.

For example, the width of the second transparent conductive portion along the first direction is W3, and a ratio of W3 to W2 may be less than or equal to 80%. For example, the width of the second transparent conductive portion along the first direction is W3, and the ratio of W3 to W2 may be 0, 10%, 20%, 30%, 40%, 50%, 60%, 70%, or 80%. In this case, the width of the second transparent conductive portion along the first direction is W3, the ratio of W3 to W2 has a large optional range, and the width of the first transparent conductive portion along the first direction may be indirectly adjusted by adjusting the width of the second transparent conductive portion along the first direction, which is further conducive to balancing the reverse breakdown voltage and the operating efficiency corresponding to the back contact solar cell.

In an actual application process, in the embodiments of the present application, a contact area between the first transparent conductive portion and the second doped semiconductor layer may be adjusted by adjusting the ratio of the width W1 of the first transparent conductive portion along the first direction to the width W2 of the third region along the first direction, to further regulate the forward leakage loss and the reverse breakdown voltage of the back contact solar cell. A size of the contact area between the first transparent conductive portion and the second doped semiconductor layer is not only related to the width W1 of the first transparent conductive portion along the first direction but also related to distribution of the reverse leakage regions along a second direction.

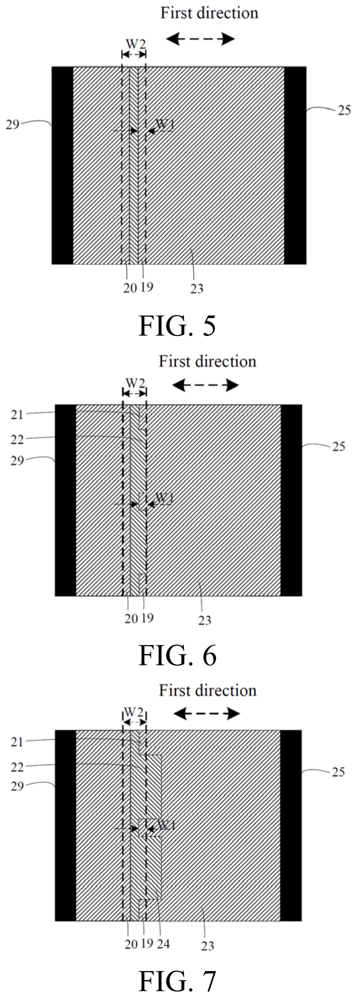

Specifically, as shown in FIG. 5, the reverse leakage regions are continuously distributed along the second direction, and the second direction intersects with the first direction. In this case, an extension length of the first transparent conductive portion 19 along the second direction is fixed, and the contact area between the first transparent conductive portion 19 and the second doped semiconductor layer is related to W1. In this case, the part of the transparent conductive layer extending from the second region into the third region (that is, the first transparent conductive portion 19) may be continuously distributed along the second direction, so that a pattern (only a pattern corresponding to the groove opening of the insulating groove) for performing selective etching on a transparent conductive material (the transparent conductive material is used for manufacturing the foregoing transparent conductive layer) that is entirely arranged on the first doped semiconductor layer and the second doped semiconductor layer is simple, which is conducive to reducing the difficulty of patterning treatment on the back contact solar cell. In addition, when the reverse leakage regions are continuously distributed along the second direction, a leakage path between the first doped semiconductor layer and the second doped semiconductor layer is more uniformly distributed, so that heat generated when the back contact solar cell is blocked is uniformly distributed in the whole solar cell area, thereby further improving the anti-burning capability of the back contact solar cell. It should be noted that, the second direction may be any direction parallel to the first surface and different from the first direction. In an embodiment, the second direction is orthogonal to the first direction.

Alternatively, as shown in FIG. 6, the reverse leakage regions may alternatively be discontinuously distributed along the second direction, and the second direction intersects with the first direction. In addition, along the second direction, the first transparent conductive portion 19 includes continuous regions 21 and discontinuous regions 22. That is, the continuous regions of the first transparent conductive portion 19 are the reverse leakage regions, and the discontinuous regions are a region between two adjacent reverse leakage regions. In this case, another implementation is provided for a distribution manner of the first transparent conductive portion 19 along the second direction. In this case, the contact area between the first transparent conductive portion 19 and the second doped semiconductor layer is not only related to W1 but also related to lengths of the continuous region 21 and the discontinuous region 22 of the first transparent conductive portion 19 along the second direction. Based on this, the reverse breakdown voltage and the forward leakage loss of the back contact solar cell can be regulated by adjusting the width of the first transparent conductive portion 19 along the first direction, and the reverse breakdown voltage and the forward leakage loss of the back contact solar cell can also be regulated by adjusting the lengths of the continuous region 21 and the discontinuous region 22 of the first transparent conductive portion 19 along the second direction, thereby improving the applicability of the back contact solar cell according to the embodiments of the present application in different application scenarios. It should be noted that, the second direction may be any direction parallel to the first surface and different from the first direction. In an embodiment, the second direction is orthogonal to the first direction.

Based on the above, according to an actual requirement, comprehensive adjustment may be performed on the ratio of W1 to W2 that affects the contact area between the first transparent conductive portion and the second doped semiconductor layer and the distribution of the reverse leakage regions along the second direction, to precisely regulate the forward leakage loss and the reverse breakdown voltage of the back contact solar cell in an actual application scenario.

For example, in a case that the reverse leakage regions are continuously distributed along the second direction, the ratio of W1 to W2 may be greater than or equal to 10% and less than or equal to 70%. In this case, a small decreasing degree of the reverse breakdown voltage caused by a small contact area between the first transparent conductive portion and the second doped semiconductor layer due to a small ratio of W1 to W2 may be prevented. In addition, a high forward leakage loss caused by a large contact area between the first transparent conductive portion and the second doped semiconductor layer due to a large ratio of W1 to W2 may also be prevented, which is further conducive to balancing the reverse breakdown voltage and the operating efficiency corresponding to the back contact solar cell.

For example, in a case that the reverse leakage regions are discontinuously distributed along the second direction, along the second direction, a ratio of the length of the discontinuous region to the length of the continuous region may be less than or equal to 90%. For example, the ratio of the length of the discontinuous region to the length of the continuous region may be 1%, 10%, 20%, 30%, 40%, 50%, 60%, 70%, 80%, or 90%. In this case, when the back contact solar cell according to the embodiments of the present application is arranged in a mounting environment with few blocking objects such as bird droppings, leaves, or dust, the ratio of the length of the discontinuous region to the length of the continuous region may be set in a large range to increase a proportion of the discontinuous region in the reverse leakage region, which is conducive to reducing the leakage loss of the back contact solar cell in the forward voltage region, thereby ensuring that the back contact solar cell has high operating efficiency. When the back contact solar cell according to the embodiments of the present application is arranged in a mounting environment with much blocking objects such as bird droppings, leaves, or dust, the ratio of the length of the discontinuous region to the length of the continuous region may be set to a small range to increase a proportion of the continuous region in the reverse leakage region, which is conducive to reducing the reverse breakdown voltage of the back contact solar cell, thereby ensuring that the back contact solar cell has a low hot spot risk. As can be seen, along the second direction, when the ratio of the length of the discontinuous region to the length of the continuous region is less than or equal to 90%, the length of the discontinuous region and the length of the continuous region may be set according to different environment requirements, thereby improving the applicability of the back contact solar cell according to the embodiments of the present application in different actual application scenarios.

For example, in a case that the reverse leakage regions are discontinuously distributed along the second direction, the ratio of W1 to W2 is greater than or equal to 20% and less than or equal to 90%. Through such setting, the applicability of the back contact solar cell according to the embodiments of the present application in different actual application scenarios can be improved. Specifically, application principles of beneficial effects in this case are similar to application principles of beneficial effects when the ratio of W1 to W2 is greater than or equal to 10% and less than or equal to 70% in a case that the reverse leakage regions are continuously distributed along the second direction described above, and details are not described herein again.

For example, in a case that the reverse leakage regions are discontinuously distributed along the second direction, the ratio of the length of the discontinuous region to the length of the continuous region is greater than or equal to 1:500 and less than or equal to 5:1. Through such setting, the applicability of the back contact solar cell according to the embodiments of the present application in different actual application scenarios can be improved. Specifically, application principles of beneficial effects in this case are similar to application principles of beneficial effects when the ratio of W1 to W2 is greater than or equal to 10% and less than or equal to 70% in a case that the reverse leakage regions are continuously distributed along the second direction described above, and details are not described herein again.

In an actual application process, as shown in FIG. 5 to FIG. 7, a part of the transparent conductive layer arranged in the second regions is defined as a third transparent conductive portion 23. Based on this, in a case that the reverse leakage regions are discontinuously distributed along the second direction, as shown in FIG. 6, the third transparent conductive portion 23 may totally cover the part of the second doped semiconductor layer corresponding to the second regions. Alternatively, as shown in FIG. 7, a part of the third transparent conductive portion 23 corresponding to the discontinuous region 22 may also be provided with a notch 24. In this case, the second doped semiconductor layer is not only arranged on the second regions but also extends to cover the first doped semiconductor layer on the third regions. In this case, the second doped semiconductor layer can not only be located on a side of the first doped semiconductor layer on the third regions facing away from the semiconductor substrate but also located on a side wall of the first doped semiconductor layer on the third regions. In addition, the transparent conductive layer is located on the first doped semiconductor layer and the second doped semiconductor layer. In this case, the transparent conductive layer can be in contact with the second doped semiconductor layer arranged on the side wall of the first doped semiconductor layer on the third regions. In this case, when the part of the part of the transparent conductive layer arranged in the second regions (that is, the third transparent conductive portion 23) corresponding to the discontinuous region 22 is provided with the notch 24, it may be ensured that the third transparent conductive portion 23 is not electrically connected to the second doped semiconductor layer in the discontinuous region 22, thereby ensuring that a contact area between the second doped semiconductor layer and the transparent conductive layer in the reverse leakage region is effectively adjusted by adjusting the lengths of the discontinuous region 22 and the continuous region 21 of the first transparent conductive portion 19 along the second direction, so that the reverse breakdown voltage and the forward leakage loss of the back contact solar cell are precisely regulated. In addition, in an actual application and manufacturing process, selective etching needs to be performed on the first transparent conductive portion 19 to enable the reverse leakage regions to be discontinuously distributed along the second direction. Based on this, when the part of the third transparent conductive portion 23 that is adjacent to the first transparent conductive portion 19 and that corresponds to the discontinuous region 22 is provided with the notch 24, there is no need to precisely stop at a junction of the first transparent conductive portion 19 and the third transparent conductive portion 23 in a process of performing etching on the first transparent conductive portion 19 to strictly control etching precision for implementing the foregoing selective etching, which is conducive to reducing the manufacturing difficulty of the back contact solar cell.

Specifically, in a case that the first transparent conductive portion has a plurality of discontinuous regions along the second direction, the third transparent conductive portion may be only provided with notches at parts corresponding to several discontinuous regions, or the third transparent conductive portion may be provided with a notch corresponding to each discontinuous region. For a size of the notch, it may be understood that, in the transparent conductive layer, a part arranged on the side of the second doped semiconductor layer facing away from the semiconductor substrate (that is, the third transparent conductive portion) need to export carriers collected by the part of the second doped semiconductor layer corresponding to the second regions to corresponding electrodes when the back contact solar cell in an operating state, so that a contact barrier between the second doped semiconductor layer and the corresponding electrodes can be reduced and a carrier transmission loss can be reduced. Based on this, a width of the notch along the first direction may be determined according to regulation requirements on the carrier transmission loss and the leakage current in an actual application scenario and an actual manufacturing process, which is not specifically limited herein.

For example, the width of the notch along the first direction may be less than or equal to 100 µm. For example, the width of the notch along the first direction may be 1 µm, 10 µm, 20 µm, 30 µm, 40 µm, 50 µm, 80 µm, or 100 µm. In this case, based on this, when the part of the third transparent conductive portion corresponding to the discontinuous region is provided with the notch, carriers collected by the part of the second doped semiconductor layer corresponding to the notch can only be transmitted into the third transparent conductive portion through an adjacent portion. In this case, a transmission loss of the carriers collected by the part of the second doped semiconductor layer corresponding to the notch is relatively high. In this case, when the width of the notch along the first direction is less than or equal to 100 µm, the notch has a relatively small range, which is conducive to controlling the transmission loss of the carriers collected in the second doped semiconductor layer in a specific range while reducing the difficulty of selective etching, thereby ensuring that the back contact solar cell has high photoelectric conversion efficiency.

In an example, as shown in FIG. 1 to FIG. 4, the back contact solar cell further includes a first electrode 25 arranged on the part of the transparent conductive layer 14 corresponding to the second regions 16 and a second electrode 29 arranged on the part of the transparent conductive layer 14 corresponding to the first regions 15, to respectively export carriers collected by the parts of the transparent conductive layer 14 corresponding to the first regions 15 and the second regions 16. A material of each of the first electrode 25 and the second electrode 29 may include any conductive material such as silver, aluminum, copper, titanium, and nickel.

In an example, as shown in FIG. 3, the back contact solar cell further includes a surface passivation layer 28 arranged on a side of the second surface of the semiconductor substrate 11, to passivate the side of the second surface of the semiconductor substrate 11, thereby reducing a carrier recombination rate of the side of the second surface. A structure and a material of the surface passivation layer 28 may at least be determined according to a requirement on the carrier recombination rate of the side of the second surface in an actual application scenario and an actual manufacturing process, which are not specifically limited herein.

For example, the surface passivation layer includes an intrinsic semiconductor passivation layer and a silicon nitride passivation layer that are sequentially stacked on the side of the second surface in the thickness direction of the semiconductor substrate. A material of the intrinsic semiconductor passivation layer includes amorphous silicon and/or microcrystalline silicon. In this case, the intrinsic semiconductor passivation layer of the surface passivation layer may be formed simultaneously when the interface passivation layer of the heterogeneous contact structure is manufactured on a side of the first surface. The silicon nitride passivation layer of the surface passivation layer may be formed simultaneously when the mask material for implementing the second passivation contact structure is manufactured on a side of the first surface, and there is no need to add an additional operation for forming the surface passivation layer, which is conducive to improving the manufacturing efficiency of the back contact solar cell.

The embodiments of the present application further provide the following seven specific examples and two comparative examples to specifically describe the operating performance of the back contact solar cell according to the embodiments of the present application.

### Example 1

Polishing and cleaning were first performed on a silicon wafer. Specifically, the silicon wafer was placed in a groove-type polishing cleaning machine for polishing, to remove a cutting damaged layer of the silicon wafer. Polished morphologies of a first surface and a second surface of the silicon wafer were regulated by controlling a temperature, a time, and a liquid medicine concentration.

A first deposition operation was performed next. Specifically, a tunneling silicon oxide layer and an intrinsic polysilicon layer were sequentially deposited on a side of the first surface of the silicon wafer. Both the tunneling silicon oxide layer and the intrinsic polysilicon layer were implemented by using a low pressure chemical vapor deposition (LPCVD) furnace. In addition, a thickness of the tunneling silicon oxide layer was 1.4 nm and a thickness of the intrinsic polysilicon layer was 120 nm.

A phosphorus diffusion process was performed then. Specifically, doping was performed on the intrinsic polysilicon layer in a high-temperature diffusion manner to form an N-type polysilicon layer, and a phosphorus-silicate glass layer was generated on a side of the N-type polysilicon layer facing away from the silicon wafer.

A first wet etching operation was performed next. Specifically, a function of this operation was to remove the foregoing phosphorus-silicate glass layer by using an HF solution. A concentration of the HF solution was 5% and an etching time was 2 min.

A second deposition operation was performed next. A silicon nitride layer with a thickness of 80 nm and a refractive index of 2.0 was deposited on a side of the first surface of the silicon wafer by using a plasma chemical vapor deposition device.

A first laser etching operation was performed next. Specifically, a part of the silicon nitride layer corresponding to the second regions and a part of the N-type doped polysilicon layer corresponding to the second regions were removed by using a laser etching process. Laser used herein may be 532 nm picosecond laser.

A second wet etching operation was performed next. A function of this operation was to form a pyramid-shaped textured structure on a surface of the second regions and the second surface and to remove the silicon nitride layer deposited through the second deposition operation.

A third deposition operation was performed next. Specifically, an intrinsic silicon layer and a P-type silicon layer that are entirely arranged were sequentially formed on a side of the first surface of the silicon wafer by using a chemical vapor deposition process. A thickness of the intrinsic silicon layer was 8 nm. A thickness of the P-type silicon layer was 15 nm, and a crystallization rate of the P-type silicon layer was 5%. In addition, an intrinsic silicon layer and an anti-reflection layer were deposited on the second surface of the silicon wafer in this operation, where the anti-reflection layer was a silicon nitride layer with a thickness of 75 nm.

A second laser etching operation and a third wet etching operation were performed next. Specifically, a part of the intrinsic silicon layer corresponding to the first regions and a part of the P-type silicon layer corresponding to the first regions were removed by using a laser etching process. Laser used herein is 532 nm picosecond laser. A second surface of a semi-finished product was placed upward by using a chained device and protected by using a water film. In addition, a side of a first surface of the semi-finished product was in contact with the HF solution, to remove an oxide layer formed in a doping process of the P-type silicon layer and the silicon nitride layer winding plated on the first surface in the third deposition operation.

Next, a transparent conductive layer was entirely deposited on a side of the first surface, where the transparent conductive layer was an indium tin oxide layer with a thickness of 50 nm.

Next, the transparent conductive layer communicating an N-type region and a P-type region was insulated, and the intrinsic silicon layer and the P-type silicon layer on the third regions were insulated, to insulate complete structures of the two polar regions. An etching slurry was used for implementing insulation. Through an etched pattern, at least a part of the transparent conductive layer was overlapped on the P-type region and the third regions, and the transparent conductive layer was enabled to physically insulate the N-type region from the P-type region. A structure of the transparent conductive layer overlapped on the P-type region and the third regions was uniformly distributed in the whole solar cell area, and the ratio of W1 to W2 was 90%.

A metallization operation was performed next. Specifically, Metal silver electrodes were prepared on transparent conductive layers at two poles, so that carriers were collected and electrodes of the whole solar cell were interconnected respectively.

### Example 2

In the back contact solar cell provided in Example 2, except that the ratio of W1 to W2 is 70%, other settings are the same as those in the back contact solar cell provided in Example 1.

### Example 3

In the back contact solar cell provided in Example 3, except that the ratio of W1 to W2 is 50%, other settings are the same as those in the back contact solar cell provided in Example 1.

### Example 4

In the back contact solar cell provided in Example 4, except that the ratio of W1 to W2 is 40%, other settings are the same as those in the back contact solar cell provided in Example 1.

### Example 5

In the back contact solar cell provided in Example 5, except that the ratio of W1 to W2 is 10%, other settings are the same as those in the back contact solar cell provided in Example 1.

### Example 6

In the back contact solar cell provided in Example 6, except that the crystallization rate of the P-type silicon layer is 0, other settings are the same as those in the back contact solar cell provided in Example 4.

### Example 7

In the back contact solar cell provided in Example 7, except that the crystallization rate of the P-type silicon layer is 10%, other settings are the same as those in the back contact solar cell provided in Example 4.

### Comparative Example 1

In the back contact solar cell provided in Comparative Example 1, except that the ratio of W1 to W2 is 95%, other settings are the same as those in the back contact solar cell provided in Example 1.

### Comparative Example 2

In the back contact solar cell provided in Comparative Example 2, except that the ratio of W1 to W2 is 5%, other settings are the same as those in the back contact solar cell provided in Example 1.

**Table 1 Test parameter table of back contact solar cells provided in Examples 1 to 7 and Comparative Examples 1 and 2**

| | Ratio of W1 to W2 (%) | Crystallization rate (%) | Average photoelectric conversion efficiency (%) | Efficiency A-level rate (greater than 26%) | Reverse breakdown voltage (V) | Hot spot reliability A-level rate (Reverse breakdown voltage is less than 11 V) |
|---|---|---|---|---|---|---|
| Comparative Example 1 | 95 | 5 | 25.7 | 20% | -1.1 | 99.8% |
| Example 1 | 90 | 5 | 26.36 | 99.5% | -2 | 99.5% |
| Example 2 | 70 | 5 | 26.40 | 99.4% | -2.5 | 99.6% |
| Example 3 | 50 | 5 | 26.41 | 99.6% | -3 | 99.7% |
| Example 7 | 40 | 10 | 26.37 | 95% | -1.5 | 99.8% |
| Example 4 | 40 | 5 | 26.41 | 99.7% | -3 | 99.5% |
| Example 6 | 40 | 0 | 26.4 | 99.5% | -4 | 99.7% |
| Example 5 | 10 | 5 | 26.45 | 99.6% | -5 | 99.8% |
| Comparative Example 2 | 5 | 5 | 26.47 | 99.8% | -10 | 50% |

It should be noted that, various data in Table 1 is obtained by respectively selecting ten thousand back contact solar cells as samples from various back contact solar cell product lines corresponding to Examples 1 to 7 and Comparative Examples 1 and 2. Efficiency test is performed on the ten thousand samples in each embodiment, and the efficiency data in the table is obtained by calculating an average thereof. Back contact solar cells whose corresponding efficiency is greater than 26% in the ten thousand samples in each embodiment are defined as efficiency A-level solar cells, and the efficiency A-level rate is calculated by dividing a quantity of the efficiency A-level solar cells in each embodiment by ten thousand. In addition, random inspection of the reverse breakdown voltage is performed on ten percent of the ten thousand samples in each embodiment, and the data of the reverse breakdown voltage in the table is obtained by calculating an average. Back contact solar cells whose corresponding reverse breakdown voltage is less than 11 V in the ten thousand samples in each embodiment are defined as hot spot reliability A-level solar cells, and the hot spot reliability A-level rate is calculated by dividing a quantity of the hot spot reliability A-level solar cells in each embodiment by ten thousand.

In the foregoing case, as can be seen from the various data in Table 1, a larger ratio of the width W1 of the first transparent conductive portion along the first direction to the width W2 of the third region along the first direction indicates a smaller reverse breakdown voltage of the back contact solar cell. When the ratio of W1 to W2 is 95%, although the back contact solar cell has a high hot spot reliability A-level rate, a leakage loss in the forward voltage region is also high. As a result, the efficiency A-level rate of the back contact solar cell corresponding to Example 1 is quite low, which does not satisfy an operating requirement. On the contrary, when the ratio of W1 to W2 is 5%, although the back contact solar cell has a high efficiency A-level rate, a leakage current in the reverse leakage region is small. As a result, the hot spot reliability A-level rate of the back contact solar cell corresponding to Example 2 is quite low, which does not satisfy an operating requirement.

In addition, as can be seen from various data in Table 1, the reverse breakdown voltage of the back contact solar cell decreases as the crystallization rate of the second doped semiconductor layer increases. However, in a specific range, the efficiency and the fill factor of the back contact solar cell increase as the crystallization rate of the second doped semiconductor layer increases, and when the crystallization rate of the second doped semiconductor layer increases to a value, the efficiency and the fill factor of the back contact solar cell decrease as the crystallization rate of the second doped semiconductor layer increases.

According to a second aspect, an embodiment of the present application provides a photovoltaic module, and the photovoltaic module includes the back contact solar cell according to the first aspect and various implementations of the first aspect.

For beneficial effects of the second aspect and various implementations of the second aspect of this embodiment of the present application, reference may be made to analysis of the beneficial effects of the first aspect and the implementations of the first aspect, and details are not described herein again.

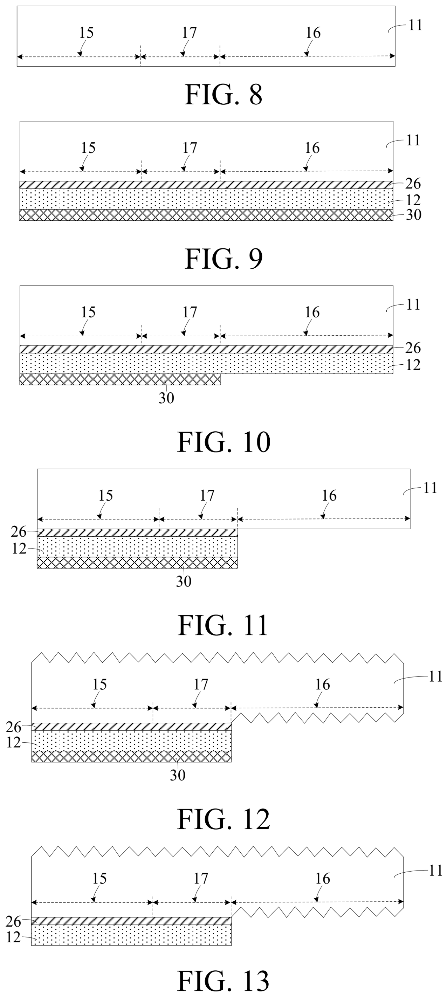

According to a third aspect, an embodiment of the present application provides a manufacturing method of a back contact solar cell. The following describes a manufacturing process according to cross-sectional views of operations shown in FIG. 8 to FIG. 20. Specifically, the manufacturing method of a back contact solar cell includes the following steps:
First, as shown in FIG. 8, a semiconductor substrate 11 is provided. The semiconductor substrate 11 includes a first surface and a second surface opposite to the first surface. The first surface includes first regions 15 and second regions 16, and third regions 17 located between the first regions 15 and the second regions 16. The first regions 15, the third regions 17, and the second regions 16 are distributed along a first direction.

Specifically, for information such as a material of the semiconductor substrate and distribution of the first regions, the second regions, and the third regions on a side of the first surface, reference may be made to the foregoing descriptions, and details are not described herein again.

Next, as shown in FIG. 11, a first doped semiconductor layer arranged on the first regions 15 and the third regions 17 is formed. The first doped semiconductor layer may be arranged on the first regions 15 and the third regions 17, or may be arranged in the first regions 15 and the third regions 17.

For example, as shown in FIG. 9, a first doped semiconductor layer that is entirely arranged on the first surface or in the first surface may be first formed. Next, as shown in FIG. 10, an insulating mask layer 30 is formed on parts of the first doped semiconductor layer 12 corresponding to the first regions 15 and the third regions 17. Next, as shown in FIG. 11, a part of the first doped semiconductor layer 12 corresponding to the second regions 16 is removed under a protection effect of the insulating mask layer 30. Then, as shown in FIG. 13, the insulating mask layer is removed.

In an actual manufacturing process, the first doped semiconductor layer that is entirely arranged on the first surface or in the first surface may be formed by using a process such as diffusion or doping source coating. When a diffusion process is used and a material of the first doped semiconductor layer includes silicon, after the first doped semiconductor layer is formed, a doped silicate glass layer is formed on a side of the first doped semiconductor layer facing away from the semiconductor substrate. In this case, patterning treatment may be performed on the doped silicate glass layer subsequently, to form parts of the doped silicate glass layer remaining on the first regions and the third regions into the insulating mask layer. Alternatively, after the doped silicate glass layer is removed, the insulating mask layer (a material of the insulating mask layer may be set according to an actual requirement and is not specifically limited herein. For example, the material of the insulating mask layer may include silicon nitride, to perform nitrogen passivation treatment on the side of the first doped semiconductor layer facing away from the semiconductor substrate) may be formed on the parts of the first doped semiconductor layer corresponding to the first regions and the third regions by using an etching process such as deposition and laser. After the first doped semiconductor layer that is entirely arranged is formed, in a case that the doped silicate glass layer is not formed, the insulating mask layer may be directly formed on the parts of the first doped semiconductor layer corresponding to the first regions and the third regions by using an etching process such as deposition and laser.

Next, under the protection effect of the insulating mask layer, the part of the first doped semiconductor layer corresponding to the second regions may be removed by using a process such as wet etching. Then, the insulating mask layer is removed, to ensure that in the manufactured back contact solar cell, the first doped semiconductor layer can be electrically connected to a second doped semiconductor layer in a reverse leakage region.

Alternatively, forming the first doped semiconductor layer on the firs regions and the third regions may include the following steps: forming a first doped semiconductor layer that is entirely arranged on the first surface or in the first surface; and selectively removing a part of the first doped semiconductor layer corresponding to the second regions by using a laser etching process. For a formation manner of the first doped semiconductor layer that is entirely arranged, reference may be made to the foregoing descriptions. After the first doped semiconductor layer is formed, the part of the first doped semiconductor layer corresponding to the second regions may be directly selectively removed by using a laser etching process by using a corresponding mask plate as a mask, so that the manufacturing efficiency of the back contact solar cell may be improved while a deposition process and a removal process of the mask layer are saved to reduce the manufacturing costs of the back contact solar cell.

It should be noted that, when the first doped semiconductor layer is arranged on the first regions and the third regions and the back contact solar cell further includes a first interface passivation layer, a first interface passivation material that is entirely arranged may be further first formed on a side of the first surface by using a process such as thermal oxidation or chemical vapor deposition. Then, selective etching may be performed on the first interface passivation material before the first doped semiconductor layer that is entirely arranged is formed, to remove a part of the first interface passivation material corresponding to the second regions, so as to obtain the first interface passivation layer. Alternatively, after the first doped semiconductor layer that is entirely arranged is formed, selective etching may be performed on the first doped semiconductor layer and the first interface passivation material by using a same insulating mask layer as a mask.

For example, in the manufactured back contact solar cell, in a case that the second surface of the semiconductor substrate and a surface of the second regions of the first surface are textured surfaces, as shown in FIG. 12, before the insulating mask layer 30 is removed, texturing treatment may be further performed on the second regions 16 and the second surface under a protection effect of the insulating mask layer 30, to form the second regions 16 and the second surface into textured surfaces. The insulating mask layer is then removed after the texturing treatment.

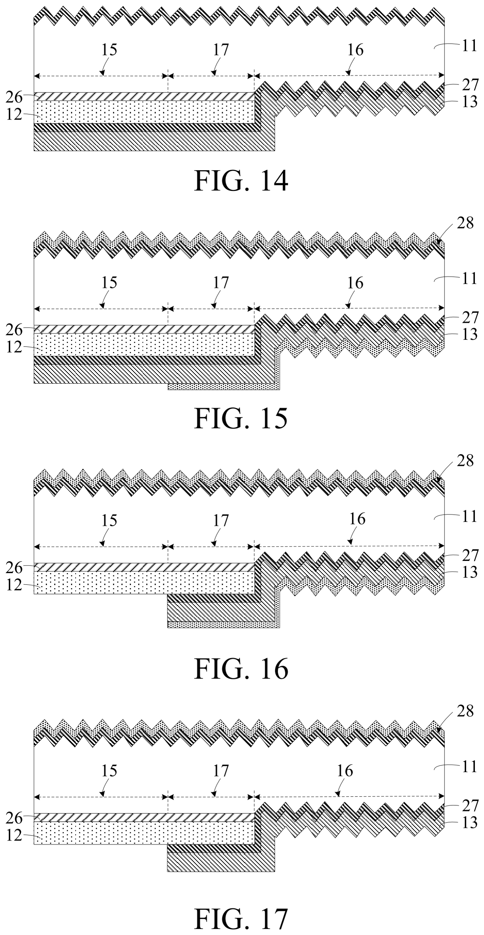

Next, as shown in FIG. 16, a second doped semiconductor layer 13 that is arranged on the second regions 16 and extends to cover a part of the first doped semiconductor layer 12 on a side facing away from the semiconductor substrate 11 and corresponds to the third regions 17 is formed. A conductivity type of the second doped semiconductor layer 13 is opposite to a conductivity type of the first doped semiconductor layer 12.

For example, as shown in FIG. 14, a second doped semiconductor layer 13 that is entirely arranged may be formed on the second regions 16 and the first doped semiconductor layer 12 by using a deposition process. Then, as shown in FIG. 15, a mask layer may be formed on parts of the second doped semiconductor layer 13 corresponding to the second regions 16 and the third regions 17 by using an etching process such as deposition and laser etching. Then, as shown in FIG. 16, by using the mask layer as a mask, a part of the second doped semiconductor layer 13 corresponding to the first regions 15 is removed by using a wet etching process. Next, as shown in FIG. 17, the mask layer is removed.

Alternatively, forming the second doped semiconductor layer that is arranged on the second regions and extends to cover the part of the first doped semiconductor layer that is on the side facing away from the semiconductor substrate and corresponds to the third regions may include the following step: forming a second doped semiconductor layer that is entirely arranged on the first doped semiconductor layer and the second regions; and selectively removing a part of the second doped semiconductor layer corresponding to the first regions by using a laser etching process. For a formation manner of the second doped semiconductor layer that is entirely arranged, reference may be made to the foregoing descriptions. After the second doped semiconductor layer is formed, the part of the second doped semiconductor layer corresponding to the first regions may be directly selectively removed by using a laser etching process by using a corresponding mask plate as a mask, so that the manufacturing efficiency of the back contact solar cell may be improved while a deposition process and a removal process of the mask layer are saved to reduce the manufacturing costs of the back contact solar cell.

It should be noted that, when the manufactured back contact solar cell further includes a second interface passivation layer, before the second doped semiconductor layer is formed, a second interface passivation material that is arranged on the second regions and extends to cover the first doped semiconductor layer may be formed by using a chemical vapor deposition process. Then, selective etching may be performed on the second interface passivation material before the second doped semiconductor layer that is entirely arranged is formed, to remove a part of the second interface passivation material corresponding to the first regions, so as to obtain the second interface passivation layer. Alternatively, after the second doped semiconductor layer that is entirely arranged is formed, selective etching may be performed on the second doped semiconductor layer and the second interface passivation material by using a same mask layer as a mask.

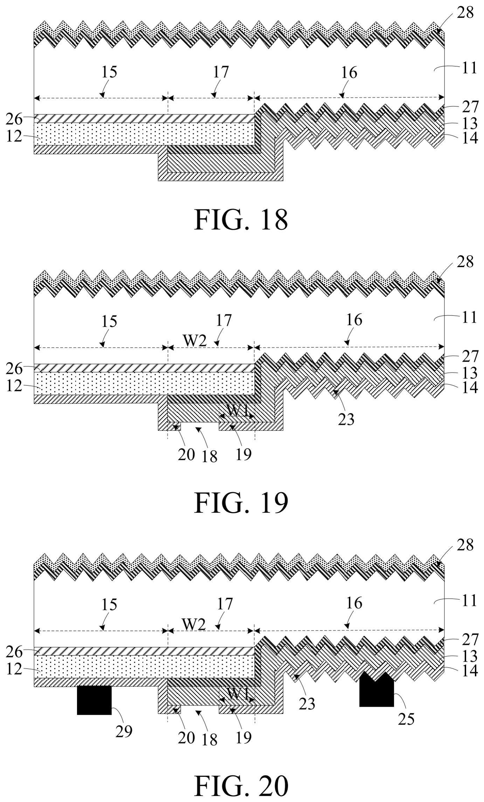

Then, as shown in FIG. 18 and FIG. 19, a transparent conductive layer 14 covering the second doped semiconductor layer and the first doped semiconductor layer 12 is formed. An insulating groove 18 is provided in the transparent conductive layer 14, to separate a part of the transparent conductive layer 14 corresponding to the first regions 15 from a part of the transparent conductive layer 14 corresponding to the second regions 16. At least a part of the third region 17 is a reverse leakage region. In the reverse leakage region, a part of the transparent conductive layer 14 extending from the second region 16 into the third region 17 is a first transparent conductive portion 19, and the first transparent conductive portion 19 is electrically connected to the first doped semiconductor layer 12 through the second doped semiconductor layer 13. A width of the first transparent conductive portion 19 along the first direction is W1, a width of the third region 17 along the first direction is W2, and a ratio of W1 to W2 is greater than or equal to 10% and less than or equal to 90%.

For example, a transparent conductive material that is entirely arranged on the first doped semiconductor layer and the second doped semiconductor layer may be formed by using a physical vapor deposition process. Then, under a protection effect of a corresponding mask plate, an insulating groove may be provided in the transparent conductive layer through a chemical corrosion slurry or laser etching. For a width of the insulating groove along the first direction and the ratio of the width W1 of the first transparent conductive portion along the first direction to the width W2 of the third region along the first direction, reference may be made to the foregoing descriptions, and details are not described herein again.

For example, after the transparent conductive layer is formed or while the insulating groove is provided in the transparent conductive layer, the manufacturing method of a back contact solar cell may further include a step: at least performing selective etching on the first transparent conductive portion, to cause the first transparent conductive portion to be discontinuously distributed along a second direction, where the second direction intersects with the first direction. For lengths of a continuous part and a discontinuous part of the first transparent conductive portion along the second direction, a width of the continuous part of the first transparent conductive portion along the second direction, and a specific orientation of the second direction, reference may be made to the foregoing descriptions, and details are not described herein again.

In addition, the operation of at least performing selective etching on the first transparent conductive portion may be performed while the insulating groove is provided in the transparent conductive layer. In this case, manufacturing of the insulating groove and execution of selective etching may be performed by using a mask plate, which is conducive to improving the manufacturing efficiency of the back contact solar cell. Certainly, the foregoing two operations may be separately performed. When a notch is provided at a part of a third transparent conductive portion corresponding to a discontinuous region of the first transparent conductive portion in the manufactured back contact solar cell, an etching agent for the selective etching operation also etches a part of the third transparent conductive portion corresponding to the discontinuous region of the first transparent conductive portion to some extent, and for an etching width of the part of the third transparent conductive portion corresponding to the discontinuous region of the first transparent conductive portion along the first direction, reference may be made to the foregoing descriptions. Details are not described herein again.

As shown in FIG. 20, a first electrode 25 may be formed on the part of the transparent conductive layer 14 corresponding to the second regions 16 by using a screen printing process, and a second electrode 29 may be formed on the part of the transparent conductive layer 14 corresponding to the first regions 15.

For beneficial effects of the third aspect and various implementations of the third aspect of this embodiment of the present application, reference may be made to analysis of the beneficial effects of the first aspect and the implementations of the first aspect, and details are not described herein again.

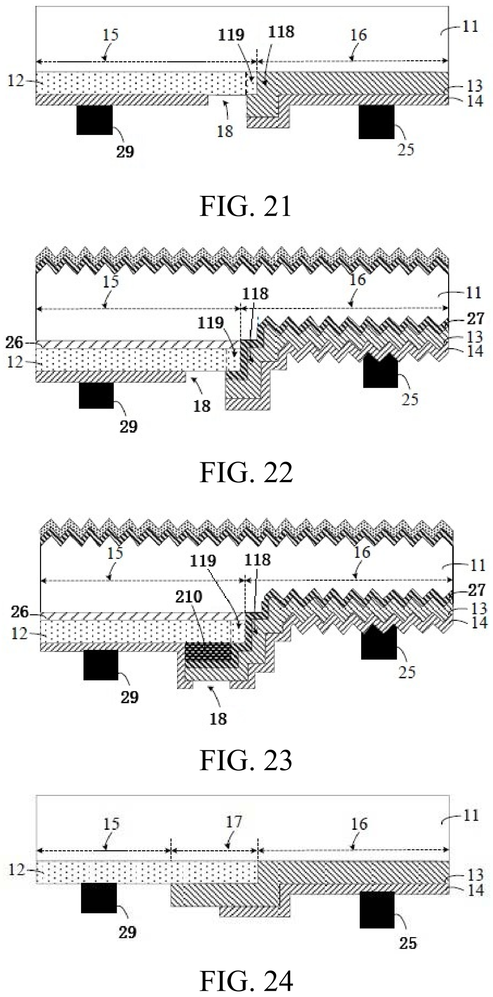

An embodiment of the present application further provides a back contact solar cell, and different from the foregoing embodiments, a hot spot risk is reduced in a manner of leakage at a side wall of a corner. Specifically, in addition to the foregoing basic structures, as shown in FIG. 21, the first surface of the semiconductor substrate 11 includes first regions 15 and second regions 16 that are alternately distributed. The first doped semiconductor layer 12 is arranged on the first regions 15. A thickness of the first doped semiconductor layer 12 is greater than a thickness of the second doped semiconductor layer 13. The second doped semiconductor layer 13 is arranged on the second regions 16 and extends to cover a part of the first doped semiconductor layer 12. The transparent conductive layer 14 covers the first doped semiconductor layer 12 and the second doped semiconductor layer 13. A run-through insulating groove 18 is provided in the transparent conductive layer 14, to physically insulate a part of the transparent conductive layer 14 electrically connected to the first doped semiconductor layer 12 and the part of the transparent conductive layer 14 corresponding to the second regions 16. The second doped semiconductor layer 13 includes a reverse leakage part 118, where the reverse leakage part 118 is electrically connected to the first doped semiconductor layer 12, and the reverse leakage part 118 is covered by the transparent conductive layer 14 extending from the second region 16. The first doped semiconductor layer 12 includes a corner region 119. The corner region 119 is from a root portion of a side wall of the first doped semiconductor layer 12 to an edge of the first doped semiconductor layer 12 close to the side wall. The reverse leakage part 118 is located in a range corresponding to the corner region 119 of the first doped semiconductor layer 12. Beneficial effects of this embodiment are similar to those of the foregoing embodiments, and details are not described herein again.

As shown in FIG. 21, the second doped semiconductor layer 13 is not only arranged on the second regions 16 but also extends to cover a part of the first doped semiconductor layer 12. In addition, the second doped semiconductor layer 13 includes the reverse leakage part 118 electrically connected to the first doped semiconductor layer 12, and the reverse leakage part 118 is covered by the transparent conductive layer 14 extending from the second region 16. In this case, the reverse leakage part 118 of the second doped semiconductor layer 13 and a part of the first doped semiconductor layer 12 located in the corner region 119 can form a built-in diode having a low reverse breakdown voltage. When the back contact solar cell is blocked, a leakage current can flow through the part of the first doped semiconductor layer 12 located in the corner region 119 and the reverse leakage part 118 of the second doped semiconductor layer 13, then flow through a part of the transparent conductive layer 14 extending from the second region 16 to cover the reverse leakage part 118, and be exported through an electrode that is in contact with the part of the transparent conductive layer 14 corresponding to the second regions 16, thereby reducing a hot spot risk of the back contact solar cell and improving an anti-burning capability of the back contact solar cell. It should be noted that, the reverse leakage part 118 is electrically connected to the first doped semiconductor layer 12, and the electrical connection manner does not include an electrical connection implemented through the semiconductor substrate 11. It may be understood that, the reverse leakage part 118 of the second doped semiconductor layer 13 may be electrically connected to the corner region 119 of the first doped semiconductor layer 12 through a tunneling mechanism or a thin dielectric layer. In addition, in the back contact solar cell provided in this embodiment of the present application, the corner region 119 of the first doped semiconductor layer 12 is from the root portion of the side wall of the first doped semiconductor layer 12 to the edge of the first doped semiconductor layer 12 close to the side wall. In addition, the reverse leakage part 118 of the second doped semiconductor layer 13 is located in the range corresponding to the corner region 119 of the first doped semiconductor layer 12. In this case, in the built-in diode, a size of a leakage contact area between the first doped semiconductor layer 12 and the second doped semiconductor layer 13 may be regulated by adjusting the thickness of the first doped semiconductor layer 12. The size of the leakage contact area affects the forward leakage loss and the reverse breakdown voltage of the back contact solar cell. Therefore, in an actual application process, balancing regulation on the forward leakage loss and the reverse breakdown voltage of the back contact solar cell may be implemented by simply adjusting the thickness of the first doped semiconductor layer 12, so that the back contact solar cell can have high conversion efficiency and a high yield in the forward voltage region while the hot spot risk and the regulation difficulty of the back contact solar cell are reduced. In addition, in an actual manufacturing process of the back contact solar cell provided in this embodiment of the present application, a film thickness of the second doped semiconductor layer 13 located in the corner region 119 is relatively smaller than a film thickness of the second doped semiconductor layer 13 located in another region. In this case, reverse breakdown in the corner region 119 can be implemented more easily, which is further conducive to transmission of a reverse leakage current. In addition, the reverse leakage part 118 is located in the range corresponding to the corner region 119, therefore compared with another part of the first doped semiconductor layer 12, a gap between the corner region 119 and the transparent conductive layer 14 located in the second regions 16 is smaller, so that a transmission path of the reverse leakage current may be shortened, and transmission resistance may be reduced, which is more conducive to transmission of the reverse leakage current and reducing the hot spot risk of the back contact solar cell.

In addition, it may be understood that, the reverse leakage part of the second doped semiconductor layer is located in the range corresponding to the corner region of the first doped semiconductor layer, so that a width of the corner region along a direction from an edge to a center of the first region may affect the size of the leakage contact area between the first doped semiconductor layer and the second doped semiconductor layer, and further affect the forward leakage loss and the reverse breakdown voltage of the back contact solar cell. Based on this, the width of the corner region in the direction from the edge to the center of the first region may be determined according to requirements on the conversion efficiency and the hot spot risk of the back contact solar cell in an actual application scenario, which is not specifically limited herein.

For example, in the direction from the edge to the center of the first region, the width of the corner region may be less than 100 nm. For example, the width of the corner region may be 5 nm, 10 nm, 20 nm, 30 nm, 40 nm, 50 nm, 60 nm, 70 nm, 80 nm, 90 nm, or 95 nm. In this case, a large forward leakage loss between the first doped semiconductor layer and the second doped semiconductor layer when the back contact solar cell is in a normal operating state caused by a large leakage contact area may be prevented, thereby ensuring that the back contact solar cell has high conversion efficiency. In addition, in an actual manufacturing process, lateral etching may be performed on the mask layer located on the first doped semiconductor layer by using a dopant, so that the corner region of the first doped semiconductor layer protrudes relative to a side wall of a remaining part of the mask layer, so as to be in contact with the second doped semiconductor layer. Based on this, when the width of the corner region falls within the foregoing range, high difficulty of lateral etching caused by an excessively large width of the corner region may be prevented, which is conducive to reducing the manufacturing difficulty of the process. Besides, there is no need to additionally use a photolithography process with expensive costs or a solution in which a plurality of layers of masks are combined to obtain a corner region with a large width, thereby reducing the manufacturing costs and improving the manufacturing efficiency of the back contact solar cell.

In addition, in an actual application process, the reverse leakage part of the second doped semiconductor layer may be only located on the side wall of the corner region. In this case, when the reverse leakage part is only located on the side wall of the corner region, in addition to an effective contact length between the first doped semiconductor layer and the second doped semiconductor layer in a length extending direction of the side wall, the size of the leakage contact area between the first doped semiconductor layer and the second doped semiconductor layer is only related to the thickness of the first doped semiconductor layer. In this case, the forward leakage loss and the reverse breakdown voltage of the back contact solar cell may be precisely regulated by simply adjusting the thickness of the first doped semiconductor layer, and the regulation difficulty may be further reduced, thereby ensuring that the back contact solar cell has a low reverse breakdown voltage and high conversion efficiency. Specifically, in this case, the reverse leakage part may be in contact with various parts of the side wall of the corner region in a thickness direction of the semiconductor substrate, or may be only in contact with a partial region of the side wall of the corner region in the thickness direction of the semiconductor substrate.

Alternatively, as shown in FIG. 22, the reverse leakage part 118 may cover an entirety of the corner region 119. In this case, a leakage channel exists between the reverse leakage part 118 of the second doped semiconductor layer 13 and the side wall of the corner region 119, and a leakage channel exists between the reverse leakage part 118 of the second doped semiconductor layer 13 and a top of the corner region 119, which is conducive to increasing the leakage contact area. Therefore, while ensuring that the back contact solar cell also has a low hot spot risk in a mounting environment with much blocking objects such as dust, there is no need to strictly control the manufacturing precision to enable the reverse leakage part 118 to be only located on the side wall of the corner region 119, thereby reducing the difficulty of the manufacturing process. Specifically, in this case, the reverse leakage part 118 may be in contact with various parts of the side wall of the corner region 119 in the thickness direction of the semiconductor substrate 11, or may be only in contact with a partial region of the side wall of the corner region 119 in the thickness direction of the semiconductor substrate 11. The reverse leakage part 118 may be in contact with various parts of a side of the corner region 119 facing away from the semiconductor substrate 11, or may be in contact with a partial region of the side of the corner region 119 facing away from the semiconductor substrate 11.

In terms of formation ranges, along a direction perpendicular to a direction in which the first regions and the second regions are alternately distributed, the reverse leakage part may be continuously distributed (referring to FIG. 22, the first regions 15 and the second regions 16 are alternately distributed in a left-right direction in FIG. 22, and the direction perpendicular to the direction in which the first regions 15 and the second regions 16 are alternately distributed is a direction perpendicular to a paper surface in FIG. 22). In this case, the leakage contact area between the reverse leakage part and the corner region can be increased, thereby further reducing the hot spot risk of the back contact solar cell. In addition, a patterning treatment operation of performing selective etching on the reverse leakage part in the length extending direction of the side wall of the corner region may be further saved, thereby improving the manufacturing efficiency of the back contact solar cell.

Alternatively, in the direction perpendicular to the direction in which the first regions and the second regions are alternately distributed, the reverse leakage part may be discontinuously distributed. In this case, a ratio of a length of a continuous region to a length of a discontinuous region in the reverse leakage part may be determined according to requirements on the hot spot risk and the conversion efficiency of the back contact solar cell in an actual application scenario, which is not specifically limited herein.

In a distribution direction of the first regions and the second regions, as shown in FIG. 22, a part of the second doped semiconductor layer 13 extending from the second region 16 onto the first doped semiconductor layer 12 may be only aligned with an edge of the corner region 119 facing away from the second regions 16. Alternatively, as shown in FIG. 23, in the direction from the edge to the center of the first region 15, the second doped semiconductor layer 13 further extends from the above of the corner region 119 to cover a remaining region of the first doped semiconductor layer 12. In addition, the back contact solar cell further includes a first insulating layer 210. The first insulating layer 210 is arranged between the remaining region of the first doped semiconductor layer 12 and the second doped semiconductor layer 13. In this case, while ensuring that the reverse leakage part 118 is located in the range corresponding to the corner region 119 of the first doped semiconductor layer 12 to cause a leakage current with a specific magnitude to exist between the reverse leakage part 118 and the corner region 119 when the back contact solar cell is blocked, so as to ensure that the back contact solar cell has a low hot spot risk, there is no need to strictly require high manufacturing precision for causing the second doped semiconductor layer 13 to only extend to the edge of the corner region 119 facing away from the second region 16, thereby reducing the manufacturing difficulty. In addition, through the first insulating layer 210 arranged between the remaining region of the first doped semiconductor layer 12 and the second doped semiconductor layer 13, an effective leakage contact area between parts of the first doped semiconductor layer 12 and the second doped semiconductor layer 13 overlapping with each other in the thickness direction of the semiconductor substrate 11 can be effectively controlled, thereby reducing a forward leakage loss and further improving the conversion efficiency of the back contact solar cell. In addition, the first insulating layer 210 is arranged between the remaining region of the first doped semiconductor layer 12 and the second doped semiconductor layer 13. In this case, a side wall of the first insulating layer 210 close to the second region 16 is recessed inward relative to the side wall of the corner region 119. Based on this, in a case that a height difference between the surface of the second region 16 and a surface of a side of the first insulating layer 210 facing away from the semiconductor substrate 11 is fixed, compared with that the first insulating layer 210 is flush with the side wall of the corner region 119, the side wall of the first insulating layer 210 close to the second region 16 is recessed inward relative to the side wall of the corner region 119, so that a step morphology with a gradually increasing height is formed between the surface of the second region 16 and the side of the first insulating layer 210 facing away from the semiconductor substrate 11, and a height change amplitude therebetween is reduced. Therefore, the second doped semiconductor layer 13 can better wrap a junction of the second region 16 and the first region 15, and film formation quality of the second doped semiconductor layer 13 at the junction of the second region 16 and the first region 15 is improved, so that transmission resistance between the corner region 119 at the junction and the reverse leakage part 118 with better film formation quality can be reduced while control on a production yield is facilitated, thereby further reducing the hot spot risk. Furthermore, in an actual manufacturing process, existence of the first insulating layer 210 may further be used as at least a partial mask layer for selectively etching the first doped semiconductor layer 12, which is conducive to simplifying a process procedure. In addition, there is also no need to completely remove the first insulating layer 210 after selective etching is performed on the first doped semiconductor layer 12, so that an etching loss of the dopant to the second regions 16 of the semiconductor substrate 11 is reduced, and a yield is improved. In addition, if the insulating groove 18 in the transparent conductive layer 14 is etched by using laser, existence of the first insulating layer 210 may further reduce influence of high-temperature laser on the first doped semiconductor layer 12 and the semiconductor substrate 11 that are below the first insulating layer.

A size of a width (that is, a width of the first insulating layer) of the second doped semiconductor layer extending from the above of the corner region to cover the remaining region of the first doped semiconductor layer affects a size of an area of a region of the first doped semiconductor layer exposed outside the second doped semiconductor layer, and further affects a formation range of the second electrode electrically connected to the first doped semiconductor layer. Therefore, the width of the first insulating layer may be determined according to a requirement on a carrier collection capability of the second electrode in an actual application scenario, which is not specifically limited herein.

For example, in the parts of the first doped semiconductor layer and the second doped semiconductor layer overlapping with each other in the thickness direction of the semiconductor substrate, in the direction from the edge to the center of the first region, a ratio of the width of the first insulating layer to the width of the corner region may be greater than or equal to 10 and less than or equal to 1000. In this case, as described above, the width of the corner region may affect a size of the leakage contact area between the reverse leakage part and the corner region. Based on this, in a case that a width of the second doped semiconductor layer extending to the first region is fixed, the ratio of the width of the first insulating layer to the width of the corner region may affect the size of the leakage contact area. Therefore, when the ratio of the width of the first insulating layer to the width of the corner region falls within the foregoing range, a large leakage contact area caused by a large width of the corner region due to a small ratio may be prevented, thereby ensuring that the back contact solar cell has high conversion efficiency. In addition, a small leakage contact area caused by a small width of the corner region due to a large ratio may also be prevented, thereby ensuring that the back contact solar cell has a high anti-burning capability.

A material and a thickness of the first insulating layer may be determined according to an actual application scenario, provided that it can be applied to the back contact solar cell provided in the embodiments of the present application. For example, the first insulating layer may include a silicon nitride layer.

In addition, it may be that only a partial region of the second doped semiconductor layer in a length extending direction of the corner region extends from the second regions to a part of the first doped semiconductor layer. Alternatively, it may be that a whole region of the second doped semiconductor layer in the length extending direction of the corner region extends from the second regions to a part of the first doped semiconductor layer. Specifically, a proportion of the part of the second regions extending to a part of the first doped semiconductor layer to various regions of the second doped semiconductor layer in the length extending direction of the corner region may be determined according to requirements on the forward leakage loss and the reverse breakdown voltage of the back contact solar cell in an actual application scenario, which is not specifically limited herein.

An embodiment of the present application further provides a back contact solar cell, and different from the foregoing embodiments, a service life of a screen printing plate is improved while a hot spot risk is reduced in a curved side line manner. Specifically, in addition to the foregoing basic structures, as shown in FIG. 24 to FIG. 26, a partial region in the third region 17 is a reverse leakage region. In the reverse leakage region, a transparent conductive layer 14 extending from the second region 16 is arranged, and the transparent conductive layer 14 is electrically connected to the first doped semiconductor layer 12 through the second doped semiconductor layer 13. A side line of a side close to the first region 15 of the transparent conductive layer 14 is a first side line 108, the first side line 108 has a periodically repeated convex-concave alternating structure, and a transition line between a convex and a concave in the convex-concave alternating structure is not parallel to the first direction.

The first side line 108 of the side close to the first region 15 of the transparent conductive layer 14 has a periodically repeated convex-concave alternating structure, a concave portion 109 in the convex-concave alternating structure may be used to control the size of the effective leakage contact area between the first doped semiconductor layer 12 and the second doped semiconductor layer 13, and the reverse leakage regions of the convex portion 200 of the transparent conductive layer 14 are uniformly distributed in the third regions 17 in a periodically repeated direction of the convex-concave alternating structure, so that heat generated when the back contact solar cell is blocked is uniformly distributed in the whole solar cell area, thereby preventing a reliability problem generated due to local heat accumulation and improving an anti-burning capability of the back contact solar cell. Generally, a screen printing etching slurry is used in a patterning process of the transparent conductive layer. The transition line between the convex and the concave in the convex-concave alternating structure is not parallel to the first direction. In this case, a contour line parallel to the first direction does not exist in a pattern contour of a screen printing plate used for forming a patterned transparent conductive layer 14 neither, so that a structural strength of the screen printing plate along the first direction is improved, and a damaged morphology of the screen printing plate caused by reuse of the screen printing plate during mass production which affects molding precision of a part of the transparent conductive layer 14 near the first side line 108 is prevented, which is conducive to causing the back contact solar cell to have a high yield, prolonging a service life of the screen printing plate, and controlling manufacturing costs of the back contact solar cell.

Specific morphologies of the first side line and the transition line of the transparent conductive layer may be determined according to an actual application scenario, provided that the first side line has a periodically repeated convex-concave alternating structure and the transition line between the convex and the concave in the convex-concave alternating structure is not parallel to the first direction.

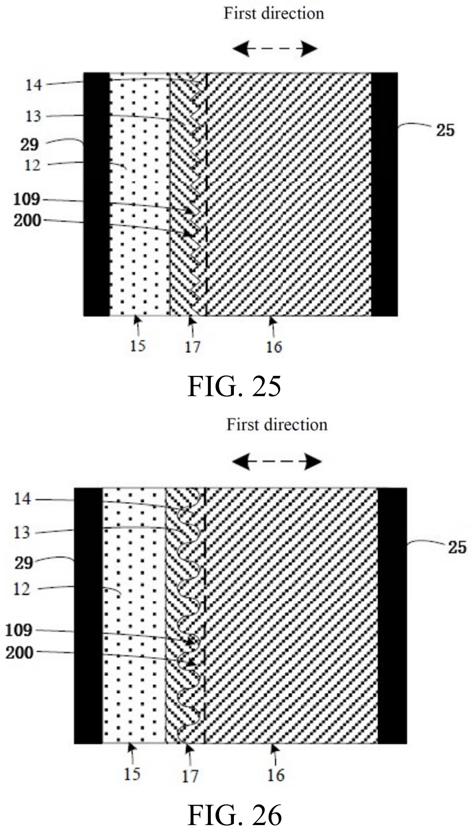

For example, as shown in FIG. 25 and FIG. 26, the transition line may be a curved line or an oblique line. In this case, the transition line not only may be a curved line having a turning, but also may be a straight or approximately straight oblique line, and have a plurality of instances, so that a specific morphology of the transition line may be set according to different requirements, to improve the applicability of the back contact solar cell provided in the embodiments of the present application in different application scenarios. In addition, the manufacturing difficulty in manufacturing the back contact solar cell can be reduced. The curved line may be an arc, or may be a non-arc having a turning. A turning angle and amplitude of the curved line may be determined according to requirements on the hot spot risk and the conversion efficiency of the back contact solar cell and a requirement on a service life of the screen printing plate for manufacturing the transparent conductive layer 14 in an actual application scenario, which are not specifically limited herein.

For the foregoing oblique line, it may be understood that, in a case that other factors such as the width of the reverse leakage region along the first direction are the same, when the transition line is an oblique line, a magnitude of an angle between the oblique line and the first direction affects a size of an area of the reverse leakage region. In addition, the magnitude of the angle further affects a strength of the screen printing plate along the first direction. Based on this, the magnitude of the angle may be determined according to the requirements on the hot spot risk and the conversion efficiency of the back contact solar cell and the requirement on the service life of the screen printing plate for manufacturing the transparent conductive layer in an actual application scenario, which is not specifically limited herein.

For example, in a case that the transition line is an oblique line, the angle between the oblique line and the first direction is greater than or equal to 5 degrees and less than or equal to 85 degrees. For example, the angle between the oblique line and the first direction may be 5 degrees, 10 degrees, 15 degrees, 20 degrees, 30 degrees, 40 degrees, 50 degrees, 60 degrees, 70 degrees, 80 degrees, or 85 degrees. In this case, when the angle between the oblique line and the first direction falls within the foregoing range, the effective leakage contact area of the reverse leakage region can be controlled within a proper range and balance between the antiburning capability and the conversion efficiency of the back contact solar cell can be adjusted. In addition, when the angle between the oblique line and the first direction falls within the foregoing range, the contour line corresponding to the first side line in the pattern contour of the screen printing plate used for forming the patterned transparent conductive layer can form a triangular morphology having high structural stability with another part of the screen printing plate, so that the structural strength of the screen printing plate along the first direction is further improved, which is conducive to further improving the service life of the screen printing plate.

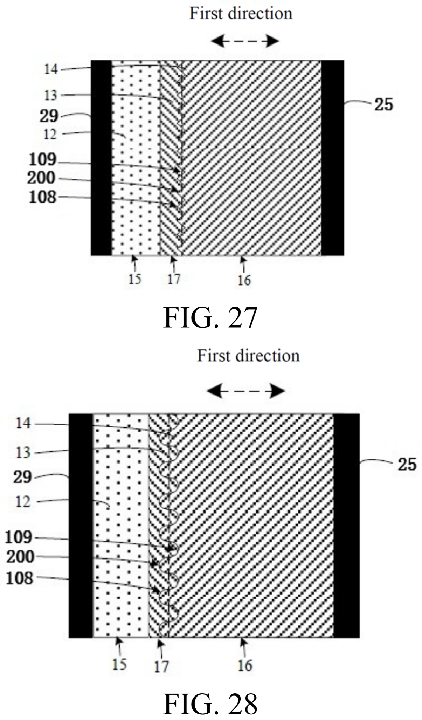

For example, as shown in FIG. 27 to FIG. 30, the first side line 108 may be a wavy line, a sawtooth line, or a trapezoidal broken line. For application principles of beneficial effects in this case, reference may be made to application principles of beneficial effects when the transition line is a curved line or an oblique line described above, and details are not described herein again. Radians corresponding to the concave portion 109 and the convex portion 200 in the wavy line, an angle of each sawtooth angle in the sawtooth line, and an inclination angle of an oblique line and a length of a transverse line in the trapezoidal broken line may be determined according to a proportion of the reverse leakage regions in the third regions 17 and the service life of the screen printing plate for manufacturing the transparent conductive layer 14 in an actual application scenario, which are not specifically limited herein.

For a length extending direction of the first side line and arrangement frequencies of convexes and concaves in the convex-concave alternating structure, it may be understood that, since sizes of the convex portion and the concave portion in the convex-concave alternating structure are fixed values, quantities of convexes and concaves in the convex-concave alternating structure per unit length affect an arrangement density of the convex portion, that is, an arrangement density of the reverse leakage regions in the third regions. Based on this, the quantities of convexes and concaves in the convex-concave alternating structure per unit length may be determined according to the requirements on the hot spot risk and the conversion efficiency of the back contact solar cell in an actual application scenario, which are not specifically limited herein.

For example, in the length extending direction of the first side line, in a unit length of 1 cm, the quantities of convexes and concaves in the convex-concave alternating structure are greater than or equal to 1 and less than or equal to 200. For example, in the length extending direction of the first side line, in the unit length of 1 cm, the quantities of convexes and concaves in the convex-concave alternating structure may be 1, 10, 30, 50, 80, 100, 120, 150, 180, or 200. In this case, it may be understood that, the effective leakage contact area of the reverse leakage region can be controlled within a proper range, so that excessive concentration of heat generated when the back contact solar cell is blocked caused by a small proportion of the reverse leakage region in the alternating region due to excessively small quantities of convexes and concaves in the convex-concave alternating structure may be prevented, and the antiburning capability of the back contact solar cell is further improved while the service life of the screen printing plate is prolonged. In addition, a large risk that an etching slurry damages, for example, squeezes the contour line corresponding to the first side line in the screen printing plate caused by excessively large quantities of convexes and concaves in the convex-concave alternating structure may also be prevented, which is conducive to prolonging the service life of the screen printing plate while reducing the hot spot risk of the back contact solar cell.

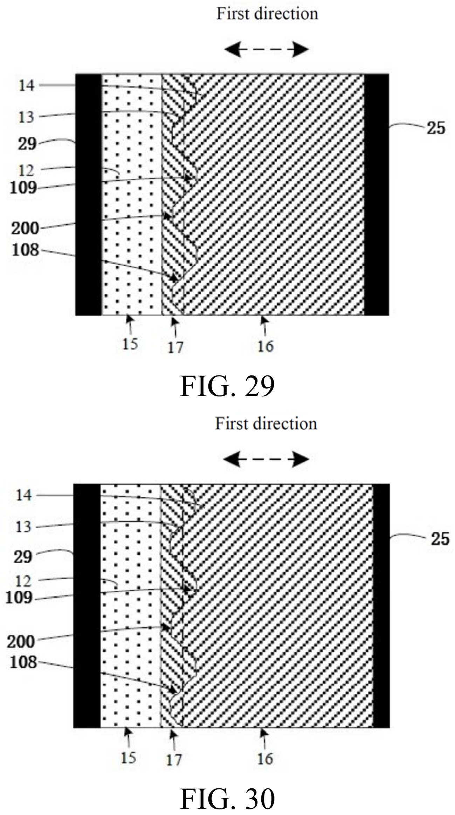

It should be noted that, in an actual manufacturing process, the etching slurry for etching the transparent conductive layer has specific fluidity, so that when the transparent conductive layer is manufactured by using the screen printing plate, the etching slurry is placed on a region exposed by the screen printing plate, and after the screen printing plate is removed, a morphology change may occur at an edge of the etching slurry due to the fluidity. Therefore, after the etching slurry etches the transparent conductive layer, a morphology of the first side line of the transparent conductive layer at the edge of the etching slurry slightly changes, but the slight change does not affect the first side line from macroscopically presenting a convex-concave alternating periodical morphology. The curved line, the oblique line, the sawtooth line, or the trapezoidal broken line described above may be regular lines shown in FIG. 27 to FIG. 29. Alternatively, the foregoing line may be an irregular line but has an approximate morphology of a curved line, an oblique line, a sawtooth line, or a trapezoidal broken line as shown in FIG. 30.

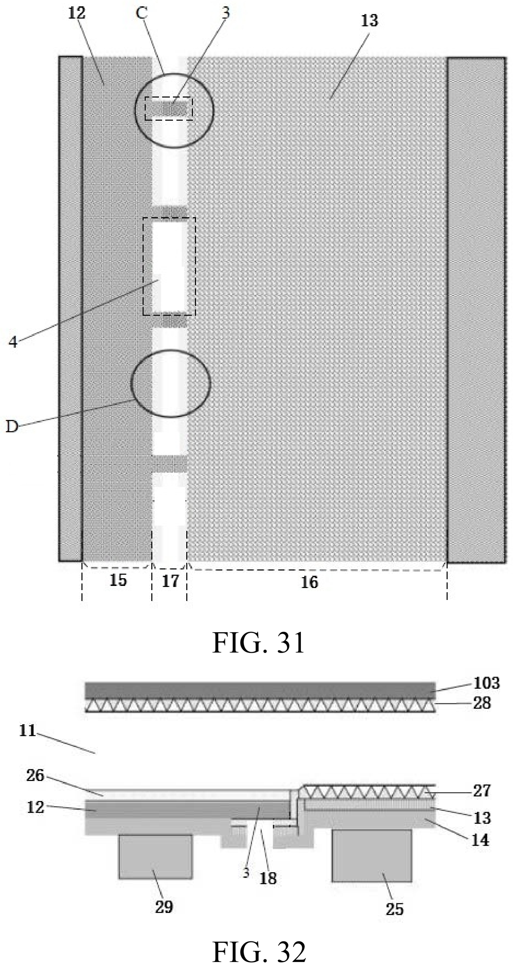

An embodiment of the present application further provides a back contact solar cell, and different from the foregoing embodiments, a hot spot risk is reduced in an interrupted leakage manner. Specifically, in addition to the foregoing basic structures, as shown in FIG. 31 to FIG. 34, the back contact solar cell includes: a leakage channel 3 and an isolation portion 4 that are spaced apart located between the first doped semiconductor layer 12 and the second doped semiconductor layer 13. A first end of the leakage channel 3 is connected to the first doped semiconductor layer 12, and a second end of the leakage channel 3 is covered by the second doped semiconductor layer 13 and the transparent conductive layer 14, where a first end of the isolation portion 4 is connected to the first doped semiconductor layer 12, a second end of the isolation portion 4 is covered by the second doped semiconductor layer 13 and the transparent conductive layer 14, and a doping concentration of the leakage channel 3 is greater than a doping concentration of the isolation portion 4; or a first end of the isolation portion 4 is connected to the first doped semiconductor layer 12, a second end of the isolation portion 4 is connected to the second doped semiconductor layer 13, a material of the isolation portion 4 is an insulating material, or a material of the isolation portion 4 is a semiconductor material and the second end of the isolation portion 4 is not covered by the transparent conductive layer 14.

The following describes a specific structure of the foregoing back contact solar cell in detail by using specific embodiments.

Embodiment 1 provides a back contact solar cell. As shown in FIG. 31 to FIG. 33, the back contact solar cell includes a semiconductor substrate 11, a first interface passivation layer 26, a second interface passivation layer 27, a first doped semiconductor layer 12, a second doped semiconductor layer 13, a transparent conductive layer 14, a leakage channel 3, an isolation portion 4, a first electrode 25, a second electrode 29, a surface passivation layer 28, and an antireflection layer 103. The semiconductor substrate 11 includes a first surface and a second surface opposite to the first surface. Both the first doped semiconductor layer 12 and the second doped semiconductor layer 13 are arranged on the first surface of the semiconductor substrate 11, and the first doped semiconductor layer 12 and the second doped semiconductor layer 13 have opposite conductivity types to respectively collect and export electrons and holes, which is conducive to forming a photocurrent.

As shown in FIG. 32, the transparent conductive layer 14 is at least arranged on a side of the second doped semiconductor layer 13 away from the semiconductor substrate 11. That is, the transparent conductive layer 14 is arranged on the side of the second doped semiconductor layer 13 away from the semiconductor substrate 11. The transparent conductive layer 14 has a high conductivity, so that collected carriers can be exported in time, thereby reducing a carrier recombination rate. In addition, whether to arrange the transparent conductive layer 14 on a side of the first doped semiconductor layer 12 away from the semiconductor substrate 11 may be selected as required. For example, in a case that the first doped semiconductor layer 12 is made of doped polysilicon, the side of the first doped semiconductor layer 12 away from the semiconductor substrate 11 may be provided with the transparent conductive layer 14 or may not be provided with the transparent conductive layer 14. In a case that the first doped semiconductor layer 12 is made of one or more of doped amorphous silicon, doped microcrystalline silicon, or doped nanocrystalline silicon, the side of the first doped semiconductor layer 12 away from the semiconductor substrate 11 may be provided with the transparent conductive layer 14.

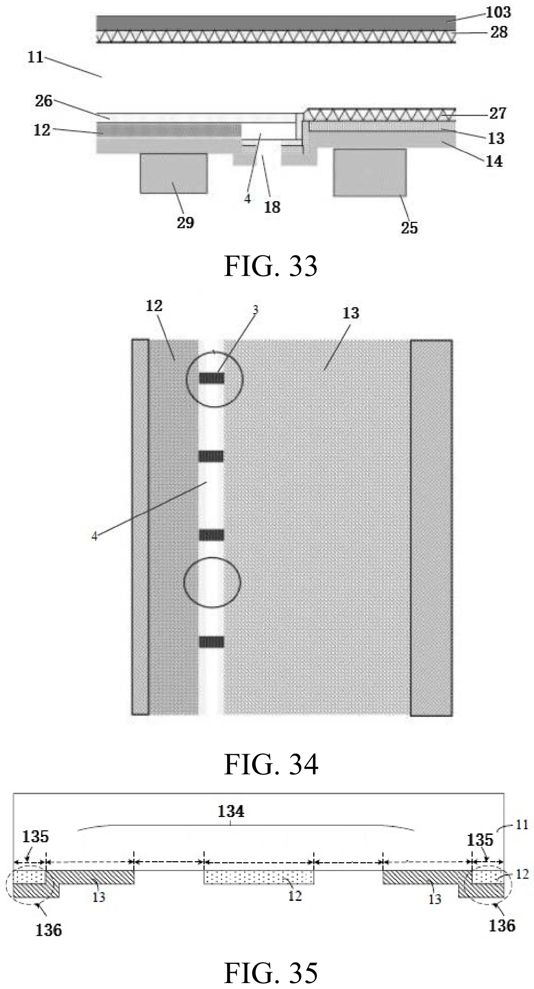

As shown in FIG. 31 and FIG. 34, the leakage channel 3 and the isolation portion 4 are located between the first doped semiconductor layer 12 and the second doped semiconductor layer 13, and the leakage channel 3 and the isolation portion 4 may be spaced apart. Specifically, a third region 17 exists between the first doped semiconductor layer 12 and the second doped semiconductor layer 13, and the leakage channel 3 and the isolation portion 4 are spaced apart in the third region 17. It may be understood that, an entity function layer of the leakage channel 3 is not virtual, and in an actual manufacturing process, the leakage channel 3 may be formed by performing doping on an intrinsic semiconductor. According to an actual situation, two, three, or more leakage channels 3 may be provided. An isolation portion 4 is arranged between adjacent leakage channels 3, and a leakage channel 3 is arranged between adjacent isolation portions 4. A first end of the leakage channel 3 is connected to the first doped semiconductor layer 12, and a second end of the leakage channel 3 is covered by the second doped semiconductor layer 13 and the transparent conductive layer 14, so that the first doped semiconductor layer 12 is electrically connected to the second doped semiconductor layer 13 through the leakage channel 3.

In Embodiment 1, as shown in FIG. 33, a first end of the isolation portion 4 is connected to the first doped semiconductor layer 12, and a second end of the isolation portion 4 is covered by the second doped semiconductor layer 13 and the transparent conductive layer 14. Since the two ends of the isolation portion 4 are respectively connected to the first doped semiconductor layer 12 and the transparent conductive layer 14, if the isolation portion 4 has a strong current transmission capability, a large leakage current flows through the isolation portion 4, leading to a decrease in the operating efficiency of the back contact solar cell. Therefore, when the back contact solar cell is designed, an isolation portion 4 having a weak current transmission capability may be selected. In a case that a material of the isolation portion 4 is a semiconductor material, a doping concentration of the leakage channel 3 may be greater than a doping concentration of the isolation portion 4. In this way, a current transmission capability of the leakage channel 3 is greater than the current transmission capability of the isolation portion 4, at least a partial region of the first doped semiconductor layer 12 is electrically connected to at least a partial region of the second doped semiconductor layer 13 through the leakage channel 3, so that when the back contact solar cell is blocked, a current may be transmitted through the second electrode 29, the first doped semiconductor layer 12, the leakage channel 3, the second doped semiconductor layer 13, the transparent conductive layer 14, and the first electrode 25.

In addition, at least a partial region of the first doped semiconductor layer 12 is separated from at least a partial region of the second doped semiconductor layer 13 through the isolation portion 4, so that low operating efficiency of the back contact solar cell caused by a large leakage current between the first doped semiconductor layer 12 and the second doped semiconductor layer 13 when the back contact solar cell operates normally is prevented, thereby ensuring that a photovoltaic module including the back contact solar cell provided in this embodiment of the present application has high photoelectric conversion efficiency in a forward voltage region.

For example, in the foregoing solution, the isolation portion 4 is an intrinsic semiconductor layer or a lightly-doped semiconductor layer (that is, the isolation portion 4 is a doped semiconductor layer, and the doping concentration of the isolation portion 4 is less than the doping concentration of the leakage channel 3), provided that the current transmission capability of the isolation portion 4 is weaker than the current transmission capability of the leakage channel 3 to ensure the operating efficiency of the back contact solar cell.

In a case that the foregoing technical solution is used, as shown in FIG. 31 and FIG. 34, the first doped semiconductor layer 12 and the second doped semiconductor layer 13 that have opposite conductivity types are distributed on a back surface side of the semiconductor substrate 11, so that carriers are effectively diverged when the back contact solar cell is in an operating state, which is conducive to forming a photocurrent. As shown in FIG. 31 and FIG. 34, the back contact solar cell provided in this embodiment of the present application further includes the leakage channel 3 located between the first doped semiconductor layer 12 and the second doped semiconductor layer 13. Based on this, each leakage channel 3 has conductive characteristics, so that in a case that the first end of the leakage channel 3 is connected to the first doped semiconductor layer 12 and the second end of the leakage channel 3 is covered by the second doped semiconductor layer 13 and the transparent conductive layer 14, when the back contact solar cell is blocked and a specific reverse voltage is provided to the blocked back contact solar cell, the current may be transmitted through the first doped semiconductor layer 12, the leakage channel 3, the second doped semiconductor layer 13, and the transparent conductive layer 14, so that the blocked solar cell is prevented from becoming a load and consuming energy generated by another solar cell irradiated by light, thereby reducing a hot spot risk.

An embodiment of the present application further provides a back contact solar cell, and a difference from the foregoing embodiments is a design of a distribution density of leakage in an edge region and a distribution density of leakage in a central region. Specifically, in addition to the foregoing basic structure, as shown in FIG. 35, the first surface of the semiconductor substrate 11 includes a central region 134 and an edge region 135 arranged at an outer periphery of the central region 134. Along a direction from a geometric center of the first surface to an edge thereof, a width of the edge region 135 is less than or equal to 1 mm. Both the first doped semiconductor layer 12 and the second doped semiconductor layer 13 are arranged on the first surface of the semiconductor substrate 11, and the first doped semiconductor layer 12 and the second doped semiconductor layer 13 have opposite conductivity types. Only a partial region of the first doped semiconductor layer 12 is electrically connected to only a partial region of the second doped semiconductor layer 13 to form reverse leakage regions 136. The reverse leakage regions 136 are at least arranged in the edge region 135, and a distribution density of the reverse leakage regions 136 in the edge region 135 is greater than a distribution density of the reverse leakage regions 136 in the central region 134.

It should be noted that, the distribution density of the reverse leakage regions may be represented as: a proportion of an area of the reverse leakage regions in a unit area or a unit length of the edge region and the central region; or the distribution density of the reverse leakage regions may be represented as: a quantity of reverse leakage regions in a unit area or a unit length of the edge region and the central region.

In a case that the foregoing technical solution, when the back contact solar cell is in a normal operating state, recombination of anisotropic carriers may occur between the first doped semiconductor layer 12 and the second doped semiconductor layer 13 that have opposite conductivity types in the reverse leakage regions 136. As a result, a leakage loss is generated, affecting the operating efficiency of the solar cell. Based on this, as shown in FIG. 35, only a partial region of the first doped semiconductor layer 12 is electrically connected to only a partial region of the second doped semiconductor layer 13 to form the reverse leakage regions 136. Based on this, there is still a part in which the reverse leakage regions 136 are not formed between the first doped semiconductor layer 12 and the second doped semiconductor layer 13, and the part in which the reverse leakage regions 136 are not formed may still be physically separated through an insulating trench or may be separated through a non-conductive structure like a chemical film layer manufactured by using an insulating material or an intrinsic semiconductor material, so that a large leakage loss when the back contact solar cell is in the normal operating state caused by a case that the reverse leakage regions 136 are formed between various regions of the first doped semiconductor layer 12 and the second doped semiconductor layer 13 is prevented, and the back contact solar cell has high operating performance. In addition, in an actual manufacturing process of the back contact solar cell, compared with the central region 134 of the semiconductor substrate 11, the semiconductor substrate 11 has poor surface flatness in the edge region 135 and has disadvantages of poor passivation and a plurality of defects. In addition, when the first doped semiconductor layer 12 and the second doped semiconductor layer 13 are formed on a side of the first surface, due to factors such as different flows and flow rates of deposited gas and/or doped gas in the central region 134 and the edge region 135, the formation quality and uniformity of the first doped semiconductor layer 12 and the second doped semiconductor layer 13 in the edge region 135 are poorer than the formation quality and uniformity in the central region 134. As a result, a recombination rate of a part of the back contact solar cell in the edge region 135 is higher than a recombination rate in the central region 134. Therefore, the edge region 135 is more suitable for arranging the reverse leakage regions 136. Based on this, in the back contact solar cell provided in this embodiment of the present application, the reverse leakage regions 136 are at least arranged in the edge region 135, and the distribution density of the reverse leakage regions 136 in the edge region 135 is greater than the distribution density of the reverse leakage regions 136 in the central region 134. In this case, the hot spot risk of the back contact solar cell can be reduced more effectively through the reverse leakage regions 136 at least arranged in a range of the edge region 135, and a leakage loss caused by existence of the reverse leakage regions 136 in a range of the central region 134 may even be reduced or eliminated, thereby ensuring a small quantity of defects in the back contact solar cell and that the central region 134 with better formation quality and uniformity of the first doped semiconductor layer 12 and the second doped semiconductor layer 13 has higher photoelectric conversion efficiency (compared with the edge region having a larger distribution density of arranged reverse leakage regions). Therefore, influence of arrangement of the reverse leakage regions 136 on the operating efficiency of the solar cell is reduced, and the operating performance of the whole back contact solar cell is improved.

In the foregoing descriptions, technical details such as composition and etching of each layer are not described in detail. However, a person skilled in the art should understand that a layer, a region, and the like of a required shape may be formed by using various technical means. In addition, to form a same structure, a person skilled in the art may further design a method that is not completely the same as the method described above. In addition, although the foregoing describes the embodiments separately, it does not mean that measures in the embodiments cannot be favorably combined.

The embodiments of the present application are described above. However, the embodiments are merely for the purpose of description, but are not intended to limit the scope of the present application. Therefore, the scope of the present application is subject to the claims and equivalents thereof. A person skilled in the art may make various replacements and modifications without departing from the scope of the present application, and these replacements and modifications shall fall within the scope of the present application.

## Claims

1. A back contact solar cell, comprising: a semiconductor substrate, a first doped semiconductor layer, a second doped semiconductor layer, and a transparent conductive layer, wherein a conductivity type of the second doped semiconductor layer is opposite to a conductivity type of the first doped semiconductor layer;
the semiconductor substrate comprises a first surface and a second surface opposite to the first surface, wherein the first surface comprises first regions and second regions that are alternately arranged at intervals, and third regions located between the first regions and the second regions; and the first regions, the third regions, and the second regions are distributed along a first direction;
the first doped semiconductor layer is arranged on the first regions and the third regions;
the second doped semiconductor layer is arranged on the second regions and extends to cover at least a part of the first doped semiconductor layer arranged on the third regions;
the transparent conductive layer covers the second doped semiconductor layer and the first doped semiconductor layer, wherein an insulating groove is provided in the transparent conductive layer, to physically insulate a part of the transparent conductive layer corresponding to the first regions from a part of the transparent conductive layer corresponding to the second regions; or the transparent conductive layer only covers the second doped semiconductor layer; and
the second doped semiconductor layer comprises a reverse leakage part, wherein the reverse leakage part is electrically connected to the first doped semiconductor layer, and the reverse leakage part is covered by the transparent conductive layer extending from the second region.

2. The back contact solar cell according to claim 1, wherein at least a part of the third region is a reverse leakage region;
a part of the transparent conductive layer extending from the second region into the third region is a first transparent conductive portion;
in the reverse leakage region, the first transparent conductive portion is electrically connected to the first doped semiconductor layer through the second doped semiconductor layer; and
a width of the first transparent conductive portion along the first direction is W1, a width of the third region along the first direction is W2, and a ratio of W1 to W2 is greater than or equal to 10% and less than or equal to 90%.

3. The back contact solar cell according to claim 2, wherein a part of the transparent conductive layer extending from the first region into the third region is a second transparent conductive portion; and a width of the second transparent conductive portion along the first direction is W3, and a ratio of W3 to W2 is less than or equal to 80%.

4. The back contact solar cell according to claim 2, wherein the reverse leakage regions are continuously distributed along a second direction that intersects with the first direction; and
the ratio of W1 to W2 is greater than or equal to 10% and less than or equal to 70%.

5. The back contact solar cell according to claim 2, wherein the reverse leakage regions are discontinuously distributed along a second direction that intersects with the first direction; and the first transparent conductive portion comprises continuous regions and discontinuous regions distributed along the second direction;
along the second direction, a ratio of a length of the discontinuous region to a length of the continuous region is less than or equal to 90%; and/or
the ratio of W1 to W2 is greater than or equal to 20% and less than or equal to 90%; and/or
a ratio of a width of the continuous region to the length of the continuous region is greater than or equal to 1:500 and less than or equal to 5:1.

6. The back contact solar cell according to claim 5, wherein a part of the transparent conductive layer arranged in the second regions is a third transparent conductive portion; and a part of the third transparent conductive portion corresponding to the discontinuous region is provided with a notch; and
a width of the notch along the first direction is less than or equal to 100 µm.

7. The back contact solar cell according to claim 1, wherein a thickness of the first doped semiconductor layer is greater than a thickness of the second doped semiconductor layer;
the first doped semiconductor layer comprises a corner region, wherein the corner region is from a root portion of a side wall of the first doped semiconductor layer to an edge of the first doped semiconductor layer close to the side wall; and
the reverse leakage part is located in a range corresponding to the corner region of the first doped semiconductor layer.

8. The back contact solar cell according to claim 7, wherein the reverse leakage part is only located on a side wall of the corner region; or
the reverse leakage part covers an entirety of the corner region; or
along a direction from an edge of the first region to a center of the first region, a width of the corner region is less than 100 nm; or
along a direction from an edge of the first region to a center of the first region, the second doped semiconductor layer further extends from the corner region to cover a remaining region of the first doped semiconductor layer; and the back contact solar cell further comprises a first insulating layer, wherein the first insulating layer is arranged between the remaining region of the first doped semiconductor layer and the second doped semiconductor layer.

9. The back contact solar cell according to claim 1, wherein a side line that is of a side close to the first region of the transparent conductive layer extending from the second regions is a first side line, the first side line has a periodically repeated convex-concave alternating structure, and a transition line between a convex and a concave in the convex-concave alternating structure is not parallel to the first direction.

10. The back contact solar cell according to claim 9, wherein the transition line is a curved line or an oblique line; or
the first side line is a wavy line, a sawtooth line, or a trapezoidal broken line; or
in a case that the transition line is an oblique line, an angle between the oblique line and the first direction is greater than or equal to 5 degrees and less than or equal to 85 degrees; or
in a unit length of 1 cm along an extending direction of the first side line, quantities of convexes and concaves in the convex-concave alternating structure are greater than or equal to 1 and less than or equal to 200.

11. The back contact solar cell according to claim 1, wherein a leakage channel and an isolation portion that are spaced apart are located between the first doped semiconductor layer and the second doped semiconductor layer; and a first end of the leakage channel is connected to the first doped semiconductor layer, and a second end of the leakage channel is covered by the second doped semiconductor layer and the transparent conductive layer, wherein
a first end of the isolation portion is connected to the first doped semiconductor layer, a second end of the isolation portion is covered by the second doped semiconductor layer and the transparent conductive layer, and a doping concentration of the leakage channel is greater than a doping concentration of the isolation portion; or
a first end of the isolation portion is connected to the first doped semiconductor layer, a second end of the isolation portion is connected to the second doped semiconductor layer, a material of the isolation portion is an insulating material, or a material of the isolation portion is a semiconductor material and the second end of the isolation portion is not covered by the transparent conductive layer.

12. The back contact solar cell according to claim 1, wherein the first surface comprises a central region and an edge region arranged at an outer periphery of the central region; and along a direction from a geometric center of the first surface to an edge thereof, a width of the edge region is less than or equal to 1 mm;
only a partial region of the first doped semiconductor layer is electrically connected to only a partial region of the second doped semiconductor layer to form reverse leakage regions; and
the reverse leakage regions are at least arranged in the edge region, and a distribution density of the reverse leakage regions in the edge region is greater than a distribution density of the reverse leakage regions in the central region.

13. The back contact solar cell according to claim 1, wherein a doping concentration of a dopant in the first doped semiconductor layer and/or the second doped semiconductor layer is greater than or equal to 1E19 cm⁻³ and less than or equal to 5E20 cm⁻³; and/or
a thickness of the first doped semiconductor layer is greater than or equal to 50 nm and less than or equal to 200 nm; and/or
a crystallization rate of the second doped semiconductor layer is less than or equal to 60%; and/or
a thickness of the second doped semiconductor layer is greater than or equal to 5 nm and less than or equal to 50 nm; and/or
a conductivity of the second doped semiconductor layer is greater than or equal to 10E-5 S/cm and less than or equal to 1 S/cm.

14. The back contact solar cell according to claim 1, wherein the semiconductor substrate is a silicon substrate; and/or
when the first doped semiconductor layer is formed on the first regions and the third regions, the back contact solar cell further comprises a first interface passivation layer located between the first doped semiconductor layer and the semiconductor substrate; and/or
the back contact solar cell further comprises a second interface passivation layer, and the second interface passivation layer is located between the second regions of the first surface and the second doped semiconductor layer and extends to a space between the second doped semiconductor layer and the first doped semiconductor layer.

15. The back contact solar cell according to claim 14, wherein a thickness of the second interface passivation layer is greater than or equal to 2 nm and less than or equal to 20 nm; or
when a doping concentration of a dopant in the first doped semiconductor layer is greater than or equal to 1E19 cm⁻³ and less than or equal to 5E19 cm⁻³, and a thickness of the second interface passivation layer is greater than or equal to 5 nm and less than or equal to 15 nm; or
when a doping concentration of a dopant in the first doped semiconductor layer is greater than 5E19 cm⁻³ and less than or equal to 1E20 cm⁻³, and a thickness of the second interface passivation layer is greater than or equal to 6 nm and less than or equal to 17 nm; or
when a doping concentration of a dopant in the first doped semiconductor layer is greater than 1E20 cm ⁻³ and less than or equal to 5E20 cm⁻³, and a thickness of the second interface passivation layer is greater than or equal to 7 nm and less than or equal to 20 nm.

16. The back contact solar cell according to claim 14, wherein when the back contact solar cell comprises the first interface passivation layer and the second interface passivation layer, the first interface passivation layer and the first doped semiconductor layer form a first passivation contact structure, and the second interface passivation layer and the second doped semiconductor layer form a second passivation contact structure, wherein
a passivated contact type of the first passivation contact structure is different from a passivated contact type of the second passivation contact structure; and/or thermal stability of the first passivation contact structure is greater than thermal stability of the second passivation contact structure; and/or the first passivation contact structure is a tunneling passivation contact structure; and/or the second passivation contact structure is a heterogeneous contact structure.

17. The back contact solar cell according to any one of claims 1 to 16, wherein the back contact solar cell further comprises a surface passivation layer arranged on a side of the second surface of the semiconductor substrate; the surface passivation layer comprises an intrinsic semiconductor passivation layer and a silicon nitride passivation layer that are sequentially stacked on a side of the second surface in a thickness direction of the semiconductor substrate; and a material of the intrinsic semiconductor passivation layer comprises at least one of amorphous silicon, microcrystalline silicon, and nanocrystalline silicon.

18. The back contact solar cell according to any one of claims 1 to 16, wherein a crosssectional area of the insulating groove is gradually reduced along a direction approaching the semiconductor substrate; and/or
A region of the transparent conductive layer in which a orthographic projection of the transparent conductive layer on the first surface does not overlap with an orthographic projection of the insulating groove on the first surface, wherein the region has a uniform thickness along the first direction.

19. The back contact solar cell according to claim 1, wherein a crystallization degree of at least a part of the second doped semiconductor layer located in the second regions is greater than a crystallization degree of a part of second doped semiconductor layer corresponding to the first transparent conductive portion; or
a crystallization degree of at least a part of the second doped semiconductor layer located in the second regions is greater than a crystallization degree of a part of the second doped semiconductor layer located in the third regions; or
a crystallization degree of at least a part of the second doped semiconductor layer located in the second regions is greater than a crystallization degree of a part of the second doped semiconductor layer covering a side wall, wherein the side wall is located at a junction of the third region and the second region.

20. The back contact solar cell according to claim 1, wherein the second doped semiconductor layer is classified into a high crystallization region and a low crystallization region; and a crystallization degree of a part of the second doped semiconductor layer located in the low crystallization region is less than a crystallization degree of a part of the second doped semiconductor layer located in the high crystallization region; and
in the second doped semiconductor layer, a part at least corresponding to the first transparent conductive portion is located in the low crystallization region, and at least a part corresponding to the second regions is located in the high crystallization region.

21. The back contact solar cell according to claim 20, wherein the low crystallization region is located in the third region; or
along the first direction, a side edge of the low crystallization region is located in the third region, and the other side edge extends to a side wall, wherein the side wall is located at a junction of the third region and the second region; or
along the first direction, a side edge of the low crystallization region is located in the third region, and the other side edge extends to the second region; or
the high crystallization region corresponds to the whole second region.

22. A photovoltaic module, comprising the back contact solar cell according to any one of claims 1 to 21.

23. A manufacturing method of a back contact solar cell, comprising:
providing a semiconductor substrate, wherein the semiconductor substrate comprises a first surface and a second surface opposite to the first surface, wherein the first surface comprises first regions and second regions, and third regions located between the first regions and the second regions; and the first regions, the third regions, and the second regions are distributed along a first direction;
forming a first doped semiconductor layer arranged on the first regions and the third regions;
forming a second doped semiconductor layer that is arranged on the second regions and extends to cover a part of the first doped semiconductor layer that is on a side facing away from the semiconductor substrate and corresponds to the third regions, wherein a conductivity type of the second doped semiconductor layer is opposite to a conductivity type of the first doped semiconductor layer; and
forming a transparent conductive layer, wherein the transparent conductive layer covers the second doped semiconductor layer and the first doped semiconductor layer, wherein an insulating groove is provided in the transparent conductive layer, to separate a part of the transparent conductive layer corresponding to the first regions from a part of the transparent conductive layer corresponding to the second regions; or the transparent conductive layer only covers the second doped semiconductor layer, wherein
the second doped semiconductor layer comprises a reverse leakage part, wherein the reverse leakage part is electrically connected to the first doped semiconductor layer, and the reverse leakage part is covered by the transparent conductive layer extending from the second region.

24. The manufacturing method of a back contact solar cell according to claim 23, wherein the forming a first doped semiconductor layer arranged on the first regions and the third regions comprises:
forming a first doped semiconductor layer that is entirely arranged on the first surface or in the first surface;
forming an insulating mask layer on parts of the first doped semiconductor layer corresponding to the first regions and the third regions;
removing a part of the first doped semiconductor layer corresponding to the second regions under a protection effect of the insulating mask layer; and
removing the insulating mask layer.

25. The manufacturing method of a back contact solar cell according to claim 23, wherein the forming a first doped semiconductor layer arranged on the first regions and the third regions comprises: forming a first doped semiconductor layer that is entirely arranged on the first surface or in the first surface; and selectively removing a part of the first doped semiconductor layer corresponding to the second regions by using a laser etching process; and/or
the forming a second doped semiconductor layer that is arranged on the second regions and extends to cover a part of the first doped semiconductor layer that is on a side facing away from the semiconductor substrate and corresponds to the third regions comprises: forming a second doped semiconductor layer that is entirely arranged on the first doped semiconductor layer and the second regions; and selectively removing a part of the second doped semiconductor layer corresponding to the first regions by using a laser etching process; and/or
the forming a transparent conductive layer covering the second doped semiconductor layer and the first doped semiconductor layer comprises: forming a transparent conductive layer that is entirely arranged on the first doped semiconductor layer and the second doped semiconductor layer; and providing the insulating groove in the transparent conductive layer by using a laser etching process.
